# EUROPÄISCHE PATENTSCHRIFT

(11) **EP 3 740 540 B1**
(45) Veröffentlichungstag und Bekanntmachung des Hinweises auf die Patenterteilung: **12.10.2022**
(21) Anmeldenummer: 19700915.2
(22) Anmeldetag: 16.01.2019
(51) Int. Cl.: C09D 11/36, C09D 11/38, C09D 11/52, H01L 51/00

(54) **SEMI-OXIDATIVER SOL-GEL-DRUCKPROZESS UND ENTSPRECHENDE TINTENFORMULIERUNGEN**
SEMI-OXIDATIVE SOL-GEL PRINTING PROCESS AND CORRESPONDING INK FORMULATIONS
PROCÉDÉ D'IMPRESSION DE SOL-GEL SEMI-OXYDANT ET FORMULATIONS D'ENCRE CORRESPONDANTES

(30) Priorität: 16.01.2018 DE 102018100836
(43) Veröffentlichungstag der Anmeldung: 25.11.2020
(73) Patentinhaber: INURU GmbH, 12489 Berlin (DE)
(72) Erfinder: RATAJCZAK, Marcin, 13353 Berlin (DE); WOLOSZKA, Maciej, 12489 Berlin (DE); BARKOWSKI, Patrick, 12459 Berlin (DE)
(74) Vertreter: Hertin und Partner Rechts- und Patentanwälte PartG mbB
(86) Internationale Anmeldenummer: PCT/EP2019/051015
(87) Internationale Veröffentlichungsnummer: WO 2019/141712

(56) Entgegenhaltungen:
- EP-A1- 3 116 019
- WO-A1-2018/069496
- ANAND S. SUBBIAH ET AL: "Inorganic Hole Conducting Layers for Perovskite-Based Solar Cells", JOURNAL OF PHYSICAL CHEMISTRY LETTERS, Bd. 5, Nr. 10, 15. Mai 2014 (2014-05-15), Seiten 1748-1753, XP055418761, US ISSN: 1948-7185, DOI: 10.1021/jz500645n

## Beschreibung

Die Erfindung betrifft ein Verfahren zur Herstellung einer druckfähigen Tinte für ein elektronisches Bauteil, wobei ein übergangsmetallhaltiges Pseudohalogenid oder Chalkogenid erst durch ein pyridinartiges oder thiolartiges Lösungsmittel komplexiert wird, um die Lösungsfähigkeit zu verbessern bzw. zu erreichen. Anschließend wird durch Filterung und Mischung mit mindestens einem Lösungsmittel die druckfähige Tinte erzeugt.

Diese kann zur Herstellung von Lochtransport- oder Elektronenblockschichten elektronischer Bauteile verwendet werden, welche ebenfalls von der Erfindung umfasst sind.

### Hintergrund und Stand der Technik

Organische Leuchtdioden (OLEDs) bestehen zumeist aus einem Sandwichaufbau, wobei sich zwischen zwei Elektroden zumeist mehrere Schichten organische halbleitender Materialien befinden. Insbesondere umfasst eine OLED eine oder mehrere Emitterschichten (engl. emitter layer EL), in welcher oder in welchen elektromagnetische Strahlung, bevorzugt im sichtbaren Bereich, durch eine Rekombination von Elektronen mit Elektronenlöchern erzeugt wird. Die Elektronen und Elektronenlöcher werden durch jeweils eine Kathode bzw. Anode bereitgestellt, wobei bevorzugt sogenannte Injektionsschichten durch eine Absenkung der Injektionsbarriere den Prozess erleichtern. OLEDs verfügen daher zumeist über Elektronen- bzw. Lochinjektionsschichten. Des Weiteren verfügen OLEDs in der Regel über Elektronen- und Lochtransportschichten (engl. hole transport layer (HTL) oder electron transport layer (ETL)), welche die Diffusionsrichtung der Elektronen und Löcher zur Emitterschicht unterstützen. Bei OLEDs sind diese Schichten aus organischen Materialien aufgebaut, bei hybriden optoelektronischen Bauteilen können die Schichten teilweise organische teilweise auch anorganische halbleitenden Materialien umfassen. Zur sprachlichen Vereinfachung werden hybride LEDs, welche organische und anorganische Halbleiterschichten umfassen können, ebenfalls als organische Leuchtdioden (OLEDs) bezeichnet.

Im Vergleich zu herkömmlichen anorganischen LEDs zeichnen sich OLEDs durch einen dünnen und flexiblen Schichtaufbau aus. Aus diesem Grunde lassen sich OLEDs deutlich vielfältiger als klassische anorganische LEDs einsetzen.

Aufgrund der Biegsamkeit sind OLEDs beispielsweise für Bildschirme, elektronisches Papier oder die Innenbeleuchtung hervorragend einsetzbar.

Die vorteilhaften Eigenschaften optoelektronischer Bauelemente umfassend organisch halbleitenden Materialien zur Lichterzeugung (OLEDs) lassen sich ebenso auf die Erzeugung von elektrischem Strom übertragen. So zeichnen sich organische Solarzellen oder hybride Solarzellen gleichfalls durch einen dünnen Schichtaufbau aus, welcher die Einsatzmöglichkeiten gegenüber klassischen anorganischen Solarzellen deutlich erhöht. Der Aufbau von organischen Solarzellen oder hybriden Solarzellen weist Ähnlichkeiten mit OLEDs oder hybriden LEDs auf. Zur sprachlichen Vereinfachung werden hybriden Solarzellen aus organischen-anorganischen Schichten ebenfalls unter den Begriff organische Solarzellen subsummiert.

Anstatt einer Emitterschicht liegen als photoaktive Schicht jedoch eine oder mehrere Absorberschichten vor. In der Absorberschicht werden aufgrund einfallender elektromagnetischer Strahlung Elektronen-Loch-Paare erzeugt. Im Gegensatz zu anorganischen Solarzellen kommt es bei der organischen Emitterschicht in der Regel zunächst zur Bildung von sogenannten Exzitonen, welche als gebundene Elektronen-Loch-Paare vorliegen. Diese werden anschließend in freie Ladungsträger getrennt.

Die weiteren Schichten umfassen Elektronen- und Lochtransportschichten sowie Elektronenextraktions- und Lochextraktionsschichten. Diese bestehen aus organischen Materialien oder aus organischen und anorganischen Materialien, deren elektrochemische Potentiale derart als Donator- und Akzeptorschichten verschoben sind, dass diese in der Solarzelle ein internes Feld erzeugen, welches die Exzitonen trennt und die freien Ladungsträger zu den Elektroden abführt. Durch den Einfall der elektromagnetischen Strahlung in der Absorberschicht werden somit an der Kathode Elektronen und an der Anode Elektronenlöcher zur Erzeugung einer Spannung bzw. eines Stromes bereitgestellt.

Geeignete luftstabile Lochtransportschichten für Druckprozesse zur Herstellung (opto-) elektronische Bauteile wie organische Leuchtdioden (OLEDs), organische Solarzellen, aber auch für elektronische Bauelemente wie Operationsverstärker (OPVs) und organische Feldeffekttransistoren (OFETs) sind nicht vorhanden oder benötigen sehr hohe Prozesstemperaturen (z.B. NiO bei über 350°C oder Cross-Linking-Polymere wie TFB bei über 190°C) und können somit nicht auf flexiblen Substraten wie PET oder PEN, welche nur Temperaturen bis 150°C aushalten, sinnvoll verarbeitet werden. Weiterhin sind Lochtransportschichten in einer normalen Bauteilarchitektur sehr weit unten angeordnet, z.B. als erste oder zweite Schicht und müssen chemisch höchst resistent sein gegenüber dem Aufdrucken der weiteren Schichten, welche bis zu 6 weitere Schichten und somit Lösemittelkombinationen sein können. Cross-Link-Polymere sind selbst sehr anfällig gegenüber dem Prozessieren in normaler Umgebung und die elektrischen Parameter der Bauteile werden dadurch stark negativ beeinflusst.

Metalloxide bieten eine für entsprechende Prozesse und für die Stabilität von Bauteilen geeignete Barriere gegenüber Wasser und Sauerstoff, geeignete Materialien für die Lochtransportschicht benötigen aber entweder sehr hohe Prozesstemperaturen (NiO über 350°C), haben zu niedrige Lochmobilitäten (CuO, Cul), sind n-Leiter (ZnO, VOx) oder gar Isolatoren (WO₃) und/oder lassen sich nicht mit Druckverfahren herstellen.

Neuerdings wurde die Klasse der Pseudohalogenide als Halbleitermaterial für Optoelektronische Bauteile identifiziert, wobei dem Kupfer(I)-thiocyanat (kurz: CuSCN) besondere Bedeutung zukommt. Es wurde bereits gezeigt, dass sich CuSCN aus Lösungsprozessen verarbeiten lässt, wobei hier als Lösemittel vor allem Alkylsulfide (Di-n-propylsulfid etc.) zum Einsatz gekommen sind, da sich das Material in keinem der üblichen Lösemittel, wie z.B. Isopropanol, gelöst hat.

Durch seine starke chemische Beständigkeit eignet sich das Material hervorragend als untere Schicht in mehrschichtig gedruckten Bauteilen. Durch geeignete Beisätze kann man die intrinsische Lochmobilität des CuSCN von 0,001 cm²/V auf bis zu 1,41 cm²/V steigern. Durch das sehr tief liegende HOMO (Highest Occupied Molecular Orbital; Valenzband in anorganischen Materialien) von 5,4 eV kann man ohne Injektionsbarriere auch in sehr tief liegende Valenzbänder bzw. HOMO-Niveaus Löcher injizieren, was bei blauen fluoreszenten Emittern und allen phosphoreszenten Emittern der Fall ist.

CuSCN ist ein Pseudohalogenid und bildet als Kristallstruktur ein Koordinationsnetzwerk. Es gehört zur Klasse der Koordinationspolymere, sprich anorganischen Polymere. Das Kupfer-Zentralatom koordiniert von drei Seiten mit dem Schwefelatom der Thiocyanat-Gruppe und von einer weiteren Seite mit dem Stickstoffatom der Thiocyanat Gruppe. Diese Bindungsart gibt dem Material seine chemische Beständigkeit gegenüber den meisten Lösungsmitteln und man ist stark beschränkt, was die Auswahl an Lösungsmitteln angeht, um eine geeignete Tintenformulierung zu finden. Die gängigen Alkylssulfide sind hochgradig stinkend, gesundheitsgefährdend und haben eine zu hohe Verdunstungsrate um in Druckprozessen eingesetzt zu werden. Im engeren Sinne wurde gezeigt, dass Lösungsmittel, die das CuSCN "lösen" es eigentlich komplexieren, sprich das Koordinations-Netzwerk des Materials angreifen und die Koordinationsstellen ersetzen. Diese so neu erzeugten Komplexe mit den Molekülen des Lösungsmittels, lösen sich wieder in dem Lösemittel selbst. Das reine CuSCN löst sich also nie sondern nur die komplexierte Form. Andererseits bilden viele Lösungsmittel keine Monomeren-Komplexe sondern 1D-, 2D- oder sogar neue 3D-Strukturen (1D = Koordinationspolymer; 2D = einzelne Flächen), die sich auch nicht lösen lassen.

Neuerdings wurde gezeigt, dass man stabile CuSCN Farbkomplexe mit Amin-liganden herstellen und damit dann aus wässriger Lösung prozessieren kann. Allerdings verändern sich bei den so hergestellten CuSCN Schichten die elektrischen Parameter ins unvorteilhafte (höhere HOMO von 5,1 eV). Grund ist die automatische Oxidierung des Cu(I) zu Cu(II) durch die protonierende Wirkung der Amin-Gruppen.

Die Verarbeitung von CuSCN oder einem anderen für (opto-) elektronische Bauteile geeignetem übergangsmetallhaltigen Pseudohalogenid oder Chalkogenid zu einer verdruckbaren Tinte ohne eine Verschlechterung deren Eigenschaften ist bislang nicht bekannt. So ist eine effiziente, einfache, schnelle und kostengünstige Verarbeitung für den industriellen Druck dieser besonders geeigneten Halbleitermaterialien zu (opto-) elektronischen Bauelementen bislang nicht möglich.

### Aufgabe der Erfindung

Aufgabe der Erfindung ist es, ein Verfahren zur Herstellung einer druckfähigen Tinte insbesondere für (opto-) elektronische Bauelemente ohne die Nachteile des Standes bereitzustellen. Insbesondere war es eine Aufgabe der Erfindung, eine Verfahren zur Herstellung einer druckfähigen Tinte insbesondere für (opto-) elektronische Bauelemente bereitzustellen, welches die Verwendung neuer Materialien sowie die Steuerung deren elektrischer Eigenschaften ermöglicht. Außerdem war eine Aufgabe der Erfindung eine Bereitstellung alternativer Lösungsmittelformulierungen für druckfähige Tinten umfassend übergangsmetallhaltige Pseudohalogenide oder Chalkogenide. Eine weitere Aufgabe der Erfindung war die Bereitstellung (opto-) elektronischer Bauelemente mit Halbleitermaterialien, welche besonders günstige elektrische Eigenschaften aufweisen und gleichzeitig schnell, effizient, einfach, verbessert und kostengünstig hergestellt werden können.

### Zusammenfassung der Erfindung

In einem ersten Aspekt betrifft die Erfindung ein Verfahren umfassend folgende Schritte:
a) Bereitstellung eines übergangsmetallhaltigen Pseudohalogenids oder Chalkogenids als Feststoff
b) Bereitstellung eines pyridinartigen oder thiolartigen Lösungsmittels
c) Mischung des Pseudohalogenids oder Chalkogenids mit dem pyridinartigen oder thiolartigen Lösungsmittel, sodass pseudohalogenidhaltige oder chalkogenidhaltige Komplexe entstehen
d) Filtern der pseudohalogenidhaltigen oder chalkogenidhaltigen Komplexe aus der Mischung aus dem vorherigen Schritt
e) Mischen der pseudohalogenidhaltigen oder chalkogenidhaltigen Komplexe mit dem pyridinartigen oder thiolartigen Lösungsmittel und/oder mit einem oder mehreren weiteren Lösungsmitteln zur Herstellung einer druckfähigen Tinte.

Der erste Schritt ist die Bereitstellung eines übergangsmetallhaltigen Pseudohalogenids oder Chalkogenids als Feststoff. Ein bevorzugtes Beispiel eines übergangsmetallhaltigen Pseudohalogenids ist Metallthiocyanat, insbesondere Kupfer(I)-Thiocyanat.

Die chemischen Elemente mit den Ordnungszahlen von 21 bis 30, 39 bis 48, 57 bis 80 und 89 bis 112 werden bevorzugt als Übergangsmetalle bezeichnet. Ein bevorzugtes Beispiel für ein übergangsmetallhaltiges Chalkogenid ist ein Sulfid, z. B. Aluminiumsulfid.

Bevorzugt handelt es sich bei den übergangsmetallhaltigen Pseudohalogeniden oder Chalkogeniden allgemein um Verbindungen der Struktur M-L, wobei insbesondere M = Übergangsmetall und L = Chalkogen oder Pseudohalogen.

Bevorzugt ist ein übergangsmetallhaltiges Pseudohalogenid Kupfer(I)-Thiocyanat.

Das pyridinartige Lösungsmittel umfasst bevorzugt einfache Pyridine mit Alkylgruppe und/oder Halogenen als Seitengruppen, z. B. ausgesucht aus der Gruppe umfassend 3-Methylpyridine, 4-Methylpyridine, 2-Methylpyridine, 3-Ethylpyridine, 4-Ethylpyridine, 2-Bromopyridine, 3-Bromopyridine, 2-Hydroxy-3-Methylpyridine und/oder 4-Tert-butyl-pyridine.

Pseudohalogenide sind bevorzugt eine Gruppe mehratomiger, resonanzstabilisierter, einwertiger Anionen mit bevorzugt größtenteils symmetrischer Ladungsverteilung, die sich ausgeprägt halogenidanalog verhalten. Die Pseudohalogenide umfassen bevorzugt lineare Anionen X⁻, wie Cyanid [CN]⁻, Fulminat [CNO]⁻, Cyanat [NCO]⁻, Thiocyanat [NCS]⁻, Selenocyanat [NCSe]⁻, Tellurocyanat [NCTe]⁻ und Azid [NNN]⁻, nichtlineare Anionen, wie Dicyanamid [N(CN)₂]⁻, Dicyanphosphid [P(CN)₂]⁻, Tricyanmethanid [C(CN)₃]⁻ und Nitrosodicyanmethanid [NOC(CN)₂]⁻sowie anionische Übergangsmetallkomplexe, wie Tetracarbonylcobaltat [Co(CO)₄]⁻ und Pentacarbonylmanganat [Mn[CO)₅]⁻.

Ähnliche bzw. gleiche Verhalten und/oder Eigenschaften von Pseudohalogeniden zu Halogeniden sind bevorzugt.

Halogenide sind vorzugsweise chemische Verbindungen zwischen Elementen der siebten Hauptgruppe (genauer der 17. Gruppe) des Periodensystems, den so genannten Halogenen, und Elementen anderer Gruppen.

Übergangsmetallhaltige Chalkogenide umfassen bevorzugt Chalkogene (insbesondere Sauerstoff, Schwefel, Selen, Tellur, Polonium und/oder Livermorium) als formale Anionen mit Übergangsmetallen oder stärker elektropositiven Übergangsmetallen. Bevorzugte übergangsmetallhaltige Chalkogenide sind Übergangsmetallsulfide.

Übergangsmetallhaltige Pseudohalogenide und Chalkogenide weisen besonders gute elektrische und chemische Eigenschaften auf, um ein robustes (opto-) elektronisches Bauteil mit verbesserten elektrischen Eigenschaften herzustellen.

Ein pyridinartiges Lösungsmittel ist bevorzugt ein Lösungsmittel, welches Eigenschaften, insbesondere chemische Eigenschaften, aufweist, die im Wesentlichen denen eines Pyridins entsprechen.

Ein pyridinartiges Lösungsmittel umfasst insbesondere ein Pyridin. Ein Pyridin ist vorzugsweise eine farblose und leichtentzündliche chemische Verbindung mit der Summenformel C₅H₅N. Sie bildet vorzugsweise das einfachste Azin, das aus einem sechsgliedrigen Ring (vorzugsweise Pyridinring genannt) mit fünf Kohlenstoffatomen und einem Stickstoffatom besteht.

Vorzugsweise umfasst das pyridinartige Lösungsmittel Pyridin, an welchem mindestens eine Position des Pyridinringes durch eine Gruppe ausgesucht aus einer Gruppe umfassend eine Alkylgruppe, eine Carboxylgruppe, eine Acetylgruppe, eine Hydroxylgruppe und/oder eine Thiolygruppe und/oder ein Halogen substituiert ist.

Mit zahlreichen Übergangsmetallionen bildet Pyridin und/oder das pyridinartige Lösungsmittel vorzugsweise Komplexe. Hierbei koordiniert Pyridin vorzugsweise stark bevorzugt mit dem freien Elektronenpaar des Stickstoffatoms an das Metallzentrum.

Komplexe, Koordinationsnetzwerke bzw. Koordinationsverbindungen sind bevorzugt aus einem oder mehreren Zentralteilchen und einem oder mehreren Liganden aufgebaut sind. Die Zentralteilchen sind dabei meist Atome bzw. Ionen von Übergangsmetallen, die ungeladen oder geladen sein können. Bevorzugt steuern in Komplexen die Liganden alle Elektronen zur Bindung bei. Zentralteilchen von Komplexen umfassen vorteilhafterweise Übergangsmetalle. Diese weisen bspw. entsprechend freie d-Orbitale auf, mit denen sich die Liganden verbinden können. Beispiele für Zentralteilchen sind kationische Zentralionen wie Cu²⁺, Mg²⁺, Fe²⁺, Fe³⁺, Ni²⁺ etc.

Ein thiolartiges Lösungsmittel ist bevorzugt ein Lösungsmittel, welches Eigenschaften, insbesondere chemische Eigenschaften, aufweist, die im Wesentlichen denen eines Thiols entsprechen.

Thiole sind bevorzugt Thioalkohole und/oder Thiophenole. Thioalkohole sind insbesondere organisch-chemische Verbindungen, die eine oder mehrere aliphatisch oder aromatisch gebundene Thiolgruppen (auch Mercaptogruppen) (-SH) als funktionelle Gruppen aufweisen. Thioalkohole entsprechen Alkoholen, bei denen das Sauerstoffatom durch ein Schwefelatom ersetzt wurde. Thiophenol ist eine vorzugsweise eine organische Schwefelverbindung. Thiophenole sind insbesondere eine Stoffgruppe von Verbindungen, die an einem Benzolring eine Thiolgruppe (-SH) aufweisen. Thiole weisen vorzugsweise metallkomplexierende Eigenschaft, insbesondere übergangsmetallkompexierende Eigenschaften auf.

Ein thiolartiges Lösungsmittel ist bevorzugt ausgesucht aus der Gruppe der aliphatisch oder aromatisch gebundenen Thiole, die bei Normbedingungen flüssig sind. Ein Beispiel für ein thiolartiges Lösungsmittel sind Thiolanisole.

Ein pyridinartiges und/oder thiolartiges Lösungsmittel ist insbesondere ein Lösungsmittel, welches mit einem übergangsmetallhaltigen Pseudohalogenid oder Chalkogenid Komplexe bildet.

Nach der Mischung übergangsmetallhaltigen Pseudohalogenids oder Chalkogenids mit dem pyridinartigen und/oder thiolartigen Lösungsmittel und der daraus bevorzugten Komplexierung (es entstehen pseudohalogenidhaltige oder chalkogenidhaltige Komplexe) werden diese Komplexe vorzugsweise aus der Mischung gefiltert.

Das Pseudohalogenid und/oder Chalkogenid kann nach der Komplexierung bevorzugt bereits als Feststoff vorliegen und wird z.B. durch ein Filterpapier herausgefiltert oder es wird zum Ausfällen aus der Lösung gebracht, indem zu dem Gemisch kurze Alkohole, wie z.B. Methanol, Ethanol und/oder Isopropanol, hinzugegeben werden um dann im nächsten Schritt mit einem Filterpapier herausgefiltert zu werden.

Vorzugsweise wird es nur durch das Komplexieren des übergangsmetallhaltigen Pseudohalogenids oder Chalkogenids möglich, diese anschließend in mindestens einem Lösungsmittel aufzulösen und so eine druckfähige Tinte zu erzeugen.

Insbesondere durch den Schritt des Filterns stehen die Komplexe nun zu einer Mischung mit einem geeigneten Lösungsmittel zur Verfügung. So wird das Problem gelöst, die übergangsmetallhaltigen Pseudohalogenide oder Chalkogenide, welche vorteilhafte physikalische und/oder chemische Eigenschaften insbesondere für (opto-) elektronische Bauelemente aufweisen, in mindestens einem Lösungsmittel gelöst zur Verfügung zu stellen und somit eine druckfähige Tinte zu erzeugen.

Für eine Massenproduktion von (opto-) elektronischen Bauteilen sind nasschemische Abscheidungsverfahren (bevorzugt auch Nassprozess genannt), wie Druckverfahren, effizient, praktisch und kostengünstig. Hierbei erfolgt eine vorzugsweise eine Flüssigkeitsprozessierung der abgeschiedenen (Halbleiter-) Materialen. Zu diesem Zweck liegen die Materialen vorzugsweise gelöst in entsprechend gewählten Lösungsmitteln vor.

Bekannte nasschemische Verfahren sind beispielsweise das Spin-Coating Verfahren (z. dt. Rotationsbeschichtung), wobei das Substrat auf einem Drehteller aufgebracht wird und Lösungen mit Polymeren oder kleinen Molekülen durch ein Aufschleudern gleichmäßig aufgetragen werden können. Beim Dip-Coating Verfahren (z. dt. Tauchbeschichtung) wird ein Substrat in eine Beschichtungslösung getaucht. Beim Herausziehen bleibt am Substrat ein Flüssigkeitsfilm zurück, sodass die Schichten nacheinander aufgetragen werden können.

Darüber hinaus zeichnen sich Druckverfahren, wie z.B. Ink-Jet (Tintenstrahldruck), Slot-Die (Schlitzdüsen-Beschichtung), Blade-Coating (Strichauftrag) durch eine besonders hohe Flexibilität bei geringen Herstellungskosten aus.

Während beim Spin-Coating oder Dip-Coating-Verfahren auch dotierte Halbleitermaterialien aufgetragen werden können, ist dies bei den gängigen Druckverfahren nicht im industriellen Maßstab nicht möglich. Durch die Dotierung der organischen Halbleiter entstehen in der Lösung Aggregate, welche ein effektives Drucken verhindern oder zumindest stark erschweren. Hierbei kommt es bei den Druckköpfen zu Verstopfungen. Diese können zwar über Filterprozesse verringert werden, doch diese Filterung der Aggregate führt gerade zu einer Aufhebung der gewünschten Dotierung. Daher sind eine möglichste einfache Dotierung sowie dessen Steuerung einer bereits aufgebrachten Schicht besonders vorteilhaft. Dieses Vorgehen wird untenstehend ebenfalls beschrieben.

Unter dem Begriff Druckverfahren sollen im weitesten Sinne alle Verfahren zur Vervielfältigung von physischen oder elektronischen Druckvorlagen zusammengefasst, wobei ein Substrat von Halbleitermaterialien in Form einer Drucktinte aufgebracht werden können. Unter dem Begriff Druckverfahren können aber auch im weitesten Sinne alle Verfahren zur Vervielfältigung von physischen oder elektronischen Druckvorlagen zusammengefasst werden, bei denen auf ein Substrat Halbleitermaterialien in Form einer Drucktinte aufgebracht werden können. Im Sinne der Erfindung wird unter dem Begriff Drucktinte oder Tinte bevorzugt eine bei Raumtemperatur flüssig vorliegende Zusammensetzung verstanden, welche ein (Halbleiter-) Material und ein Trägermittel umfasst oder daraus besteht. Das Trägermittel ist bevorzugt ein Lösungsmittel oder Lösungsmittelgemisch in welchem das zu verdruckende Halbleitermaterial gelöst vorliegt, sodass die hierdurch aufgebrachte mindestens eine Schicht für das optoelektronische Bauelement mit gängigen Druckverfahren aufgetragen werden können.

Als Druckverfahren kommen beispielsweise Offsetdruck, Siebdruck, Flexodruck oder insbesondere Tintenstrahldruckverfahren und/oder Schlitzdüsen-Beschichtungsverfahren in Frage. Im Gegensatz zu beispielsweise Verdampfungsverfahren zeichnen sich die Druckverfahren insbesondere durch eine hohe Tauglichkeit für die Massenproduktion aus. Außerdem ist das Verfahren besonders kostengünstig.

Nach der Komplexierung und der Filterung findet vorzugsweise eine Mischung der pseudohalogenidhaltigen oder chalkogenhaltigen Komplexe mit dem pyridinartigen oder thiolartigen Lösungsmittel und/oder mit einem oder mehreren weiteren Lösungsmitteln zur Herstellung einer druckfähigen Tinte statt. Das pyridinartige oder thiolartige Lösungsmittel kann dem pyridinartigen oder thiolartigen Lösungsmittel entsprechen, welches zur Komplexierung (Schritt c)) verwendet wurde. Es kann sich auch um ein anderes pyridinartiges oder thiolartiges Lösungsmittel handeln. Das eine oder mehrere weitere Lösungsmittel kann vorzugsweise ein zusätzlich zum verwendeten pyridinartigen oder thiolartigen Lösungsmittel verwendetes Mittel handeln, es kann aber auch als mindestens ein Lösungsmittel ohne ein pyridinartiges oder thiolartiges Lösungsmittel im Schritt e) verwendet werden. Die verwendeten Lösungsmittel können dabei vorzugsweise nach bevorzugten Verhaltensweisen der Tinte ausgewählt werden. Vorzugsweise sollten die Lösungsmittel die gebildeten Komplexe tatsächlich lösen, was aber vorteilhafterweise im Gegensatz zu dem unkomplexierten übergangsmetallhaltigen Pseudohalogenid oder Chalkogenid als Feststoff nun einfach möglich ist.

Es kann ebenso bevorzugt sein, dass das pyridinartige oder thiolartige Lösungsmittel, welches zur Komplexierung genutzt wird, auch direkt als eines des mindestens einen Lösungsmittels der Tinte genutzt wird, so dass eine Filterung manchmal (je nach pyridinartigem Lösungsmittel) nicht nötig ist und somit der Schritt der Filterung und ggf. der anschließenden Mischung wegfallen.

Es kann bevorzugt sein, zum Mischen im Schritt e) das gleiche pyridinartige oder thiolartige Lösungsmittel zu verwenden, wie bereits zur Komplexierung. Nichtsdestotrotz ist dabei bevorzugt, eine vorhergehende Filterung vorzunehmen. Zum einen kann durch das Herausfiltern die Reinheit des Pseudohalogenides oder Chalkogenides verbessert werden, da die herausgefilterten Materialien vorzugsweise nur die Komplexe sind. Verunreinigungen werden daher bevorzugt nicht herausgefiltert und gelangen dadurch vorzugsweise nicht in die druckfähige Tinte. Nur Stoffe bzw. Verunreinigungen, die genauso durch das Lösemittel komplexiert werden, würden vorzugsweise mit herausgefiltert. Weiterhin kann bevorzugt durch das Verhältnis von Pseudohalogenid bzw. Chalkogenid zum komplexierenden Lösemittel der Grad der Oxidation des Metallatoms während des Schritts des Komplexierens beeinflusst werden, wie untenstehend beschrieben wird. Beispielsweise werden beim Komplexieren in einer Lösung mit viel Pseudohalogenid oder Chalkogenid (Konzentrationen über 10 Gramm pro Liter), also einem hohen Verhältnis, weit mehr Metallatome, z.B. Cu(I)SCN, in eine höhere Oxidationsstufe oder Oxidationszahl oxidiert, z. B. in Cu(II)SCN⁻, als wenn man das Komplexieren mit niedrigeren Konzentrationen durchführt, wie z.B. weniger als 1 Gramm Pseudohalogenid oder Chalkogenid pro Liter (g/L), also einem geringen Verhältnis. Das Material in der höheren Oxidationsstufe bedeutet bevorzugt eine Dotierung und somit kann bevorzugt durch diesen Vorgang der Grad der Dotierung gesteuert werden. Daher kann aus diesen Gründen bei der Oxidierung ein unterschiedliches Verhältnis von Pseudohalogenid bzw. Chalkogenid zum pyridinartigen oder thiolartigen Lösungsmittel erwünscht sein als bei der späteren Mischung mit mindestens einem Lösungsmittel in Schritt e). Darüber hinaus wird beim Komplexieren bevorzugt auch das pyridin- oder thiolartige Lösemittel mitoxidiert und es entstehen unerwünschte Pyridin-N-oxide, welches sehr hohe Siedetemperaturen haben und die Tinte negativ beeinflussen, bspw. durch zu hohe Siedetemperatur von über 270°C, wodurch ein Trocknen bei den gewünschten Prozessparametern erschwert und/oder verhindert wird. Durch das Filtern der komplexierten Kristalle kann also bevorzugt verhindert werden, dass die Pyridin-N-Oxide in der Lösung vorhanden sind. Eine bevorzugte Beschreibung der beim Komplexieren ablaufenden Reaktion ist:

*2 Cu(I)SCN* + *O₂ + Pyridin -> Cu₂(II)O(SCN)₂* + *Pyridin-N-oxid*

Als Beispiel soll nun das Herstellungsverfahren einer konkreten Tinte unter Verwendung von Kupfer(I)-Thiocyanat (CuSCN) als übergangsmetallhaltiges Pseudohalogenid beschrieben werden: es wurde herausgefunden, dass die Komplexierung des CuSCN mit einigen Lösungsmitteln als Liganden ein neues Material erzeugt, welches Separat herausgefiltert werden kann und sich dann in neuen Lösungsmittel zu einer Tinte verarbeiten lässt. Weiterhin kann dieses Material bei milden Temperaturen (<120°C) wieder zu CuSCN zersetzt werden und ist bis 70°C stabil an Luft. Bevorzugt können Lösungsmittel, die das CuSCN komplexieren auch direkt als Lösungsmittel für die neu entstandenen Komplexe eingesetzt werden. Je nach molaren Proportionen des angesprochenen Lösemittels kann dabei vorzugsweise auch eine teilweise Oxidation des Cu(I) zu Cu(II) erreicht werden. Dadurch lassen sich bewusst Dotierungen der entstehenden CuSCN Schicht mit Cu(II)Oxid erzeugen und somit die Ladungsträgerdichte und Mobilität erhöhen. Man kann eine Oxidation beim Druckvorgang haben, wenn gewünscht, oder auch nicht. Man kann vorzugsweise den Grad der Oxidation steuern und so die Dotierung der erzeugten Schichten mit Sauerstoff kontrollieren. Dazu geeignete Lösungsmittel sind einfache Pyridine mit Alkylgruppen und/oder Halogenen als Seitengruppen, z. B. 3-Methylpyridine, 4-Methylpyridine, 2-Methylpyridine, 3-Ethylpyridine, 4-Ethylpyridine, 2-Bromopyridine, 3-Bromopyridine, 2-Hydroxy-3-Methylpyridine, 4-Tert-butyl-pyridine etc. Diese Lösungsmittelklasse greift in das CuSCN Netzwerk ein und koordiniert das CuSCN zu Monomeren, die sich dann lösen lassen. Mit diesen Komplexen lässt sich dann eine Tinte für den Druckder CuSCN Schicht erstellen. Dass es sich bei dem Vermischen des CuSCN mit den genannten pyridinartigen Lösungsmitteln nicht um ein herkömmliches Lösen handelt sondern um eine Komplexierung, erkennt man vorzugsweise schnell an dem Farbumschlag. Das CuSCN ist ein farbloses Material und die pyridinartigen Komplexe des CuSCN sind stark Farbgebend (Gelb, Orange, Grün etc.). Im engeren Sinne handelt es sich hierbei vorzugsweise um einen "Sol-Gel-Prozess" bei dem eine Oxidation verhindert wird, oder nur in kontrolliertem Maße stattfindet. Bis dato sind Sol-Gel-Prozesse vorzugsweise im Stand der Technik nur für Metalloxide oder andere oxidierte Materialien bekannt.

Die entsprechenden Tintenformulierungen beinhalten das komplexierte und gelöste (nicht dispergierte!) Pseudohalogenid (und/oder einen anderen anorganischen Feststoff wie z.B. Magnesiumsulfid; MgS oder Kupfer(I)oxid; Cu₂O), das komplexierende pyridinartige Lösungsmittel (wie z.B. 3-Methylpyridin) und weitere Lösungsmittel, die die Druck- und Schichtbildungseigenschaften beim Trocknen verbessern, wie z.B. Tert-Butanol.

Die so entstehende Tinte kann sehr individuell den verschiedensten Anforderungen angepasst werden, sowohl was die Verarbeitung/das Auftragen der Tinte angeht (Temperatur, Feuchtigkeit/Zusammensetzung Umgebungsatmosphäre, Trocknungszeit etc.).

Es können verdruckbare Tinten mit verbesserten Druck- und elektrischen Eigenschaften bereitgestellt werden, insbesondere zur Herstellung (opto-) elektronischer Bauelemente wie OLEDs, OFETs, OPVs und organische Solarzellen.

Jedoch ist auch das Herstellungsverfahren der Tinte selber vereinfacht und verbessert. Es werden nur wenige Schritte zur Herstellung einer druckfähigen Tinte umfassend übergangsmetallhaltige Pseudohalogenide oder Chalkogenide als Feststoff benötigt, gleichzeitig ist eine hohe Flexibilität bei der Auswahl von Lösungsmitteln zur Herstellung einer druckfähigen Tinte gegeben. Es müssen vorteilhafterweise keine stark stinkenden und/oder gesundheitsgefährdenden Lösungsmittel wie im Stand der Technik verwendet werden.

Zusammengefasst betrifft die Neuerung der Erfindung den Prozess des Komplexierens von Pseudohalogeniden mit pyridinartigen Liganden um diese löslich zu machen und damit mit Druckprozessen verarbeiten zu können. Die pyridinartigen Liganden können bei sehr milden Temperaturen wieder abgestoßen werden (< 150°C) und es liegt nach der thermischen Behandlung wieder das unlösliche Ausgangsmaterial vor. Konkret geht es bevorzugt um das Material Kupfer(I)-Thiocyanat (kurz: CuSCN), welches ein sehr guter p-Halbleiter ist (Loch Mobilitäten von 10-5 cm²/V bis 1,4 cm²/V), vorzugsweise sehr niedrig liegende Lochtransportniveaus besitzt (HOMO ~ 5,4 eV), im eigentlichen Sinne absolut unlöslich ist und sich als Lochtransportschicht für opto-elektronische Bauteile eignet wie OLEDs, OPVs, OFETS etc. Zusätzlich beinhaltet die Komplexierung mit den pyridinartigen Liganden die Erstellung einer druckfähigen Tinte für den Funktionaldruck mit Tintenstrahl, Schlitzdüsen und ähnlichen Verfahren.

In einer bevorzugten Ausführungsform betrifft die Erfindung ein Verfahren umfassend folgende Schritte:
a) Bereitstellung eines Kupfer(I)-Thiocyanats als Feststoff
b) Bereitstellung eines pyridinartigen oder thiolartigen Lösungsmittels
c) Mischung des Kupfer(I)-Thiocyanats mit dem pyridinartigen oder thiolartigen Lösungsmittel, sodass Kupfer(I)-Thiocyanathaltige Komplexe entstehen
d) Filtern der Kupfer(I)-Thiocyanathaltigen Komplexe aus der Mischung aus dem vorherigen Schritt
e) Mischen der Kupfer(I)-Thiocyanathaltigen Komplexe mit dem pyridinartigen oder thiolartigen Lösungsmittel und/oder mit einem oder mehreren weiteren Lösungsmitteln zur Herstellung einer druckfähigen Tinte.

Insbesondere Kupfer(I)-Thiocyanat (CuSCn) hat außerordentlich gute, elektrische, chemische und/oder mechanische Eigenschaften für (opto-) elektronische Bauelemente, welche aufgrund dieser Ausführungsform einfach und flexibel gedruckt bzw. nasschemisch hergestellt werden können. Durch seine starke chemische Beständigkeit eignet sich das Material hervorragend als untere Schicht in mehrschichtig gedruckten Bauteilen. Durch geeignete Beisätze kann man die intrinsische Lochmobilität des CuSCN von 0,001 cm²/V auf bis zu 1,41 cm²/V steigern. Durch das sehr tief liegende HOMO (Highest Occupied Molecular Orbital; Valenzband in anorganischen Materialien) von 5,4 eV kann man ohne Injektionsbarriere auch in sehr tief liegende Valenzbänder bzw. HOMO-Niveaus Löcher injizieren, was bei blauen fluoreszenten Emittern und allen Phosphoreszenten Emittern der Fall ist.

In einer bevorzugten Ausführungsform der Erfindung ist das Pseudohalogenid ein Metallthiocyanat und/oder Metallisothiocyanat bevorzugt ausgewählt aus einer Gruppe umfassend Natriumthiocyanat, Kaliumthiocyanat, Silberthiocyanat, Calciumthiocyanat, Wolframthiocyanat, Vanadiumthiocyanat, Molybdänthiocyanat, Silikonthiocyanat und/oder anderen (Übergangs-) Metallthiocyanaten, besonders bevorzugt ein Kupfer(I)-Thiocyanat.

Natriumthiocyanat ist vorzugsweise eine chemische Verbindung mit der Formel NaSCN, welche bei Raumtemperatur als Feststoff vorliegt.

Kaliumthiocyanat (KSCN, auch: Kaliumrhodanid) ist vorzugsweise ein Salz der Thiocyansäure.
Calciumthiocyanat hat bevorzugt die chemische Formel C2CaN2S2

Silberthiocyanat, bevorzugt AgSCN, ist vorzugsweise eine weiße, koordinationspolymere Verbindung mit einer Zickzack-Kettenstruktur.

Auch die anderen aufgeführten Metallthiocyanate sind dem Fachmann bekannt.

Diese Materialien haben besonders bevorzugt elektrische und chemische Eigenschaften, wie z. B. ein tief liegendes HOMO und eine starke chemische Beständigkeit, was insbesondere bei Herstellungsprozessen von Bauelementen mit mehreren Schichten von Vorteil ist.

In einer weiteren bevorzugten Ausführungsform der Erfindung ist das Pseudohalogenid ausgesucht aus der Gruppe Metallcyanid, Metallfulminat, Metallcyanat, Metallselenocyanat, Metalltellurocyanat und/oder Metallazid.

Diese Materialien erlauben eine hohe Flexibilität bei der Herstellung von Bauelementen mit maßgeschneiderten elektrischen Eigenschaften.

In einer weiteren bevorzugten Ausführungsform der Erfindung ist das Pseudohalogenid ein nichtlineares Metallanion, bevorzugt ausgesucht aus der Gruppe umfassend Metalldicyanamid, Metalldicyanphosphid, Metalltricyanmethanid und/oder Metallnitrosodicyanmethanid.

Ein Anion ist vorzugsweise ein negativ geladenes Ion.

Ein nichtlineares Metallanion ist bevorzugt ein Anion, welches keine lineare Molekülgeometrie aufweist. In der Chemie beschreibt die lineare Molekülgeometrie vorzugsweise eine Geometrie um ein Zentralatom, das an zwei andere Atome (oder Liganden) gebunden ist, welche einen Bindungswinkel von 180 ° aufweisen. Ein Beispiel für ein lineares organisches Moleküle ist Acetylen (HC = CH). Nichtlineare Metallanionen weisen bevorzugte chemische Eigenschaften auf.

In einer weiteren bevorzugten Ausführungsform der Erfindung ist das Chalkogenid ein Sulfid bevorzugt ausgesucht aus einer Gruppe umfassend Cadmiumsulfid, Zinksulfid, Molybdändisulfid, Siliciumdisulfid, Wolframdisulfid, Aluminiumsulfid und/oder Vanadiumsulfid ist.

Ein Sulfid ist bevorzugt ein Salz beziehungsweise Alkyl- oder Arylderivate des Schwefelwasserstoffs (H₂S). Die Salze gehören insbesondere zur Stoffgruppe der Metall-Schwefel-Verbindungen und enthalten bevorzugt das Sulfid-Anion S²⁻ als Bestandteil.

Cadmiumsulfid ist bevorzugt eine chemische Verbindung aus Cadmium und Schwefel und gehört zur der II-VI-Verbindungshalbleiter - Gruppe.

Zinksulfid bzw. Zink(II)-sulfid (ZnS) ist bevorzugt das Zink-Salz der Schwefelwasserstoffsäure und ein II-VI-Verbindungshalbleiter. Wegen seines hohen Brechungsindizes kann es in optoelektronischen Bauelementen oft gleichzeitig als elektrische und optisch relevante Schicht verwendet werden und ist lumineszent.

Molybdän(IV)-sulfid, bzw. Molybdändisulfid (MoS₂) ist vorzugsweise ein grauschwarzes, kristallines Sulfid des chemischen Elements Molybdän und weist bevorzugt graphitartige Eigenschaften auf.

Siliciumdisulfid ist bevorzugt eine anorganische chemische Verbindung des Siliciums aus der Gruppe der Sulfide.

Wolframdisulfid bzw. Wolfram(IV)-sulfid ist vorzugsweise eine chemische Verbindung aus der Gruppe der Wolframverbindungen und der Sulfide.

Aluminiumsulfid (Al₂S₃) ist vorzugsweise eine chemische Verbindung aus der Gruppe der Sulfide.

Vanadiumsulfid bzw. Vanadiumsulfide sind bevorzugt anorganische chemische Verbindungen des Vanadiums aus der Gruppe der Sulfide. Bevorzugt umfasst es Vanadiumsulfid (V₂S₂), Vanadium(III)-sulfid (V₂S₃), Vanadium(IV)-sulfid (VS₂), Vanadium(V)-sulfid (V2S5) und/oder Patrónit (VS₄).

Diese Ausführungsform ist aufgrund der verbesserten elektrischen Eigenschaften für besonders effiziente Bauelemente geeignet.

In einer weiteren bevorzugten Ausführungsform der Erfindung ist das übergangsmetallhaltige Pseudohalogenid oder Chalkogenid ein vorstehend beschriebenes Material, insbesondere ein Metallthiocyanat oder Metallisothiocyanat, bevorzugt ausgewählt aus einer Gruppe umfassend Natriumthiocyanat, Kaliumthiocyanat, Silberthiocyanat, Calciumthiocyanat, Wolframthiocyanat, Vanadiumthiocyanat, Molybdänthiocyanat, Silikonthiocyanatund/oder anderen Metallthiocyanaten, bevorzugt ein Kupfer(I)-Thiocyanat, wobei in Schritt c) eine Dotierung des Materials durch eine teilweise Oxidation des Metalls, bevorzugt des Kupfer(I) zu Kupfer (II) erfolgt und das Ausmaß der Oxidation bei der Komplexierung gesteuert wird durch das Verhältnis von Feststoff zum pyridinartigen oder thiolartigen Lösungsmittel, wobei ein höheres Verhältnis eine erhöhte Oxidation bedeutet.

Bevorzugt sorgt eine Oxidation bei den verwendeten Materialien für eine Dotierung. Insbesondere sorgt eine Oxidation für eine p-Dotierung. Eine Oxidation bedeutet bevorzugt eine erhöhte Oxidationszahl oder -stufe. Das Ausmaß der Oxidation beschreibt bevorzugt den Anteil des am in der Tinte enthaltenen übergangsmetallhaltigen Pseudohalogenids oder Chalkogenids, welcher oxidiert ist und welcher z. B. in % beschrieben werden kann.

Es hängt allerdings bevorzugt vom Material bzw. dessen Verwendung ab, ob die Dotierung vorteilhaft ist. Eine p-Dotierung im Fall von Cu(I)SCN zu Cu(II)SCN - bzw. zu Cu(II)SCN⁻ ist bspw. vorteilhaft, weil das Material dadurch vorteilhafterweise seine Lochtransporteigenschaften verbessert und es eben bevorzugt zum Verdrucken einer Lochtransportschicht verwendet werden soll. Daher ist eine Oxidation insbesondere bevorzugt zur Dotierung von zu verdruckenden Lochtransportschichten.

Es könnten aber bevorzugt auch Materialfälle auftreten, bei denen eine p-Dotierung in einem Material erfolgt, was vorzugsweise als Elektronentransportschicht verwendet wird, dann wäre es vorzugsweise nachteilig. Es könnte jedoch dort bspw. zu einer Verringerung einer n-Dotierung zur Steuerung der Stärke dieser n-Dotierung verwendet werden. Durch die Steuerung des Verhältnisses wie beschrieben beim Komplexieren kann der Grad der Dotierung vorteilhafterweise sehr präzise gesteuert werden. Konzentrationen von unter 1 g/L oxidieren bevorzugt zu einem geringeren Anteil und bewirken damit eine niedrige Dotierung.

Höhere Konzentrationen oxidieren vorzugsweise mehr Material, woraus insbesondere eine höhere Dotierung folgt. Die Konzentration ist bevorzugt in Gramm pro Liter angegeben. Niedrige Konzentration sind bevorzugt unter 1 g/L und haben bevorzugt eine geringe Oxidation zur Folge und hohe Konzentrationen sind bevorzugt mehr als 10 g/L und haben bevorzugt eine hohe Oxidation zur Folge.

Diese Ausführungsform kann sich bevorzugt ebenfalls beziehen auf ein Pseudohalogenid ausgesucht aus der Gruppe Metallcyanid, Metallfulminat, Metallcyanat, Metallselenocyanat, Metalltellurocyanat und/oder Metallazid ist, ein Pseudohalogenid, welches ein nichtlineares Metallanion, bevorzugt ausgesucht aus der Gruppe umfassend Metalldicyanamid, Metalldicyanphosphid, Metalltricyanmethanid und/oder Metallnitrosodicyanmethanid ist und/oder ein Chalkogenid, welches ein Sulfid bevorzugt ausgesucht aus einer Gruppe umfassend Cadmiumsulfid, Zinksulfid, Molybdändisulfid, Siliciumdisulfid, Wolframdisulfid, Aluminiumsulfid und/oder Vanadiumsulfid ist.

Bevorzugt kann die Oxidierung bzw. Oxidation während dieses Prozesses, ähnlich zur thermischen Behandlung (siehe unten), ebenfalls durch die Sättigung der Umgebungsatmosphäre mit Sauerstoff, wobei mehr Sauerstoff eine erhöhte Oxidation bedeutet, gesteuert werden.

In einer weiteren bevorzugten Ausführungsform der Erfindung ist das pyridinartige Lösungsmittel ein Pyridin, an welchem mindestens eine Position des Pyridinringes durch eine Gruppe ausgesucht aus einer Gruppe umfassend eine Alkylgruppe, eine Carboxylgruppe, eine Acetylgruppe, eine Hydroxylgruppe und/oder eine Thiolgruppe und/oder ein Halogen substituiert ist.

Eine Substitution bezeichnet bevorzugt eine chemische Reaktion, bei der eine Ersetzung eines Atome oder von Atomgruppen in einem Molekül durch ein anderes Atom oder eine andere Atomgruppe stattfindet.

Eine Alkylgruppe ist vorzugsweise mindestens ein Teil eines Moleküls, welcher aus miteinander verbundenen Kohlenstoff- und Wasserstoffatomen besteht. Ein Beispiel in Form einer einfachen Alkylgruppe ist eine Methylgruppe -CH₃. Weitere Beispiele sind vorzugsweise die Ethylgruppe -CH₂-CH₃ und die n-Propylgruppe -CH2-CH2-CH3. Eine allgemeine Formel für Alkylgruppen ist vorzugsweise CₙH₂ₙ₊₁.

Die Carboxylgruppe ist vorzugsweise die funktionelle Gruppe -COOH der Carbonsäuren.

Eine Acetylgruppe bezeichnet vorzugsweise die folgenden chemische Struktur: -C(O)CH₃ und setzt sich aus einer Carbonyl- und einer Methylgruppe zusammen.

Die Hydroxylgruppe (-OH) ist vorzugsweise die funktionelle Gruppe der Alkohole und Phenole.

Die Thiolgruppe (-SH) ist vorzugsweise eine funktionelle Gruppe, die analog zur Hydroxylgruppe (-OH) aufgebaut ist, wobei das stark elektronegative Sauerstoff-Atom durch das weniger elektronegatives Schwefel-Atom ersetzt ist.

Ein Halogen bildet bevorzugt die 7. Hauptgruppe des Periodensystems der Elemente und umfasst folgende sechs Elemente: Fluor, Chlor, Brom, Iod, Astat und Tenness.

Dabei können bevorzugt eine Alkylgruppe, eine Carboxylgruppe, eine Acetylgruppe, eine Hydroxylgruppe, eine Thiolygruppe und/oder ein Halogen als Seitengruppe des Pyridins auftreten. Ein Halogen kann auch zusätzlich an den genannten Gruppen substituiert sein.

Eine Seitengruppe oder -kette bezeichnet in der organischen Chemie vorzugsweise einen Substituenten einer Hauptkette und/oder cyclischen Gruppe, bspw. eine kurze Kohlenstoffkette (Alkylgruppe), die von einer längeren Kohlenstoffkette oder einem Ring abzweigt.

Die vorstehend beschriebenen pyridinartigen Lösungsmittel dieser Vorzugsvariante sind besonders gut geeignet für eine schnelle und einfache Komplexierung von übergangsmetallhaltigen Pseudohalogeniden oder Chalkogeniden.

In einer weiteren bevorzugten Ausführungsform der Erfindung ist das pyridinartige Lösungsmittel ausgewählt aus einer Gruppe umfassend Methylpyridine, Ethylpyridine, Bromopyridine und/oder Tert-Butylpyridine.

Die Methylpyridine bilden bevorzugt eine Stoffgruppe organischer Verbindungen, welche zu den Heterocyclen (genauer: Heteroaromaten) gehört. Sie umfasst vorzugsweise einen Pyridinring, der mit einer Methylgruppe (also vorzugsweise ein Alkylgruppe) substituiert ist. Methylpyridine weisen dem Pyridin ähnliche Eigenschaften auf.

Ethylpyridine haben vorzugsweise die Formel C₇H₉N. Beispiele für Ethylpyridine umfassen bevorzugt 2- Ethylpyridine, 3- Ethylpyridine und/oder 4- Ethylpyridine.

Ein Beispiel eines Bromopyridins ist vorzugsweise 2-Brompyridin, welches zu den Heterocyclen (genauer: Heteroaromaten) und bevorzugt einen Pyridinring umfasst, der in 2-Position mit Brom substituiert ist.

Ein Beispiel für Tert-Butylpyridine ist 2,6-Di-tert-butylpyridin, eine organische Verbindung, die vorzugsweise zu den Heterocyclen (genauer: Heteroaromaten) zählt und einen Pyridinring umfasst, der in 2- und 6-Position zwei tert-Butylreste aufweist.

Diese Ausführungsform ist nicht nur für ein effizientes Komplexieren geeignet, sondern weist auch verbesserte Lösungseigenschaften auf.

In einer weiteren bevorzugten Ausführungsform der Erfindung ist das thiolartige Lösungsmittel ausgewählt aus einer Gruppe umfassend Thiolanisole, Alkylthiophene, Allylthiophene und/oder Thioglycolsäuren.

Thioanisol ist vorzugsweise eine chemische Verbindung aus der Gruppe der Thioether, ist insbesondere ein Schwefelanalogon von Anisol und hat bevorzugt die Summenformel C₇H₈S.

Ein Beispiel für ein Alkylthiophene ist vorzugsweise Poly(3-alkylthiophene).

Ein Beispiel für Allylthiophene ist vorzugsweise 2-Allylthiophene mit ebenfalls der Summenformel C₇H₈S.

Thioglycolsäure ist vorzugsweise eine farblose, viskose Flüssigkeit, welche zur Gruppe der Thiole gehört. Thioglycolsäure hat bevorzugt die Summenformel C₂H₄O₂S.

Die Lösungsmittel dieser Ausführungsform haben verbesserte Druckeigenschaften.

In einer weiteren bevorzugten Ausführungsform der Erfindung umfasst die druckfähige Tinte
a) 0,1 - 10 Gew.-% der pseudohalogenidhaltigen Komplexe und
b) 5 - 99,9 Gew.-% des pyridinartigen oder thiolartigen Lösungsmittels,
wobei sich die Gew.-%) auf das Gesamtgewicht der Tinte beziehen und die Summe der Gew.-% kleiner oder gleich 100 ist.

Es können weitere Elemente, insbesondere weitere Lösungsmittel umfasst sein.

Diese Mischung hat sich als besonders geeignet für die Herstellung einer elektrisch besonders leistungsfähigen Schicht als Teil eines (opto-) elektronischen Bauelements herausgestellt und ist besonders gut für die Verwendung in kommerziell erhältlichen Druckern geeignet.

In einer weiteren bevorzugten Ausführungsform der Erfindung umfasst die druckfähige Tinte
a) 0,1 - 10 Gew.-% der pseudohalogenidhaltigen oder chalkogenidhaltigen Komplexe und
b) 5 - 99,7 Gew.-% des pyridinartigen oder thiolartigen Lösungsmittels,
c) 0,1 - 50 Gew.-% eines zweiten Lösungsmittels, welches flüssig bei Normbedingungen ist,
d) 0,1 - 50 Gew.-% eines dritten Lösungsmittels, welches flüssig bei Normbedingungen ist,
wobei sich die Gew.-% auf das Gesamtgewicht der Tinte beziehen und die Summe der Gew.-% kleiner oder gleich 100 ist.

Mit Normbedingungen sind vorzugsweise 273,15 K und 1013,25 hPa gemeint.

In dieser Ausführungsform besteht eine erhöhte Flexibilität zur Gestaltung erwünschter Eigenschaften der Tinte, welche insbesondere durch die Zugabe des zweiten und dritten Lösungsmittels gesteuert werden können. Bei Normbedingungen flüssige Lösungsmittel sind hierfür besonders gut geeignet, gleichzeitig verringern sich durch diese Eigenschaften die Anforderungen an den Aufbau zur Herstellung bezüglich des zweiten und dritten Lösungsmittels, da Normbedingungen besonders einfach zu erzeugen sind.

In einer weiteren bevorzugten Ausführungsform der Erfindung erhöht das zweite Lösungsmittel die Druckfähigkeit der Tinte, wobei das zweite Lösungsmittel ein Lösungsmittel mit niedrigerer Oberflächenspannung bei Normbedingungen als das pyridinartige oder thiolartige Lösungsmittel ist.

Die Oberflächenspannung beschreibt vorzugsweise die infolge von Molekularkräften auftretende Erscheinung bei Flüssigkeiten, ihre Oberfläche klein zu halten. Die Oberfläche einer Flüssigkeit verhält sich z. B. wie eine gespannte, elastische Folie.

Die Oberflächenspannung ist vorzugsweise definiert anhand eines Bügels mit der Breite *L*, in dem ein Flüssigkeitsfilm eingespannt ist. Wird der Flüssigkeitsfilm durch eine Kraft *F* parallel zur Oberfläche und senkrecht zu *L* um *dx* auseinandergezogen, so ist die Oberflächenspannung vorzugsweise proportional zur Kraft und lautet bevorzugt *y* = *F*/*2L.*

Einem Fachmann sind verschiedene Möglichkeiten zur Bestimmung der Oberflächenspannung von verschiedenen Stoffen bei Normbedingungen bekannt, z. B. durch Nachschlagen in einem Tabellenwerk, durch Berechnung und/oder Messung, bspw. durch einen oben beschriebenen Bügel, mit einem Tensiometer, mithilfe des Kapillareffekts und/oder durch Messung des Kontaktwinkels.

Durch geeignete Auswahl des zweiten Lösungsmittels gemäß dieser Ausführungsform kann die Druckfähigkeit aufgrund der Herabsetzung der Oberflächenspannung des Gemischs positiv beeinflusst werden und es können z. B: feinere Strukturen gedruckt werden.

Druckfähigkeit bezieht sich bevorzugt, z. B. im Falle des Tintenstrahldrucks, darauf, dass bei dem Druck die Bildung der Tröpfchen an den Tintenstrahldüsen im Wesentlichen mit gleichem Volumen, mit gleicher Spritzwinkel senkrecht nach unten und mit gleicher Geschwindigkeit erfolgt. Weiterhin sollten die Tröpfchen vorzugsweise beim Ausschalten der Düsen und Wiedereinschalten der Düsen das im Wesentlichen gleiche Verhalten aufweisen. Weiterhin sollte das Verhalten der Tröpfchen an den Düsen sich im Wesentlichen zeitlich nicht verändern, wie z.B. der Spritzwinkel, das Volumen oder die Geschwindigkeit.

Begriffe wie im Wesentlichen, ungefähr, etwa, ca. etc. beschreiben bevorzugt einen Toleranzbereich von weniger als ± 40%, bevorzugt weniger als ± 20%, besonders bevorzugt weniger als ± 10 %, noch stärker bevorzugt weniger als ± 5% und insbesondere weniger als ± 1%. Ähnlich be-schreibt bevorzugt Größen die ungefähr gleich sind. Teilweise beschreibt bevorzugt zu mindestens 5 %, besonders bevorzugt zu mindestens 10 %, und insbesondere zu mindestens 20 %, in einigen Fällen zu mindestens 40 %. Wird vorstehend z. B. beschrieben, dass ein Spritzwinkel an einer Druckerdüse sich im Wesentlichen nicht ändert ist, so ist damit bevorzugt gemeint, dass der Spritzwinkel innerhalb der oben genannten Toleranzbereiche konstant bleibt.

Dafür werden bevorzugt Lösungsmittelkombinationen eingesetzt, wobei meistens jedes der Lösemittel eine positive Auswirkung auf einen der genannten Parameter zur Druckfähigkeit der Tinte aufweist.

Durch die bevorzugt Hinzugabe eines Lösemittels mit niedrigerer Oberflächenspannung bei Normbedingungen als das pyridinartige oder thiolartige Lösungsmittel wird vorteilhafterweise die gesamte Oberflächenspannung der Lösung herabgesenkt. Eine niedrigere Oberflächenspannung bewirkt eine stabilere Ejektion der Tröpfchen aus den Druckkopfdüsen in senkrechter Linie zum Substrat anstatt ein unkontrolliertes seitliches Spritzen der Tröpfchen ausgehend vom Druckkopf.

Als Analogie kann man sich die Hinzugabe eines "Surfactants" bzw. Tensids oder Benetzungsmittels zu Gemischen vorstellen, wodurch bevorzugt die Benetzbarkeit erhöhen soll und/oder die Oberflächenspannung ebenfalls herabgesetzt werden soll. Vorliegend soll vorteilhafterweise eben die Tinte das Druckkopfmaterial gut benetzen können, damit eine stabile Ejektion der Tinte aus dem Druckkopf erfolgen kann und die Tinte soll bevorzugt auch das Material, auf das sie verdruckt wird gut benetzen können, so dass keine Defekte im gedruckten Film entstehen, sprich bevorzugt ein einheitlicher homogener Film entsteht.

In einer weiteren bevorzugten Ausführungsform der Erfindung erhöht das dritte Lösungsmittel die Trocknungszeit der Tinte, wobei das das dritte Lösungsmittel ein Lösungsmittel mit höherer Viskosität bei Normbedingungen als das pyridinartige oder thiolartige Lösungsmittel ist.

Bevorzugt wird auch die Trocknungsfähigkeit der Tinte erhöht, was besonders bevorzugt gleichbedeutend ist mit einer Erhöhung der Trocknungsfähigkeit.

Die Viskosität bezeichnet bevorzugt die Zähflüssigkeit von Flüssigkeiten und/oder Gasen (Fluiden). Umso größer die Viskosität, desto dickflüssiger ist das Fluid bevorzugterweise; umso niedriger die Viskosität ist, desto dünnflüssiger ist es vorzugsweise.

Die Viskosität bestimmter Stoffe bei Normbedingungen ist vorzugsweise für viele Materialien bekannt, des Weiteren ist sie für einen Fachmann leicht feststellbar, z. B. durch Messung, bspw. mit einem Viskosimeter (z. B. gemäß EN ISO 3219) und/oder einem Rheometer.

Durch die Ausführungsform kann die Trocknungsfähigkeit der Tinte vorteilhafterweise entscheidend verbessert werden. Damit ist insbesondere gemeint, dass sich die Trocknungszeit erhöht bzw. die Trocknungsgeschwindigkeit erniedrigt.

Eine erhöhte Viskosität erniedrigt bevorzugt die Trocknungsgeschwindigkeit. Bevorzugt trocknet die Tinte nicht zu schnell, da sie sonst z. B. schon an den Druckkopfdüsen eintrocknen könnte. Das ist ein weit verbreitetes Problem beim Tintenstrahldruck. Eine zu schnelle und unkontrollierte Trocknung des Nassfilmes nach dem Druck wird bevorzugt auch Inhomogenitäten bei dem Trockenfilm erzeugen, was bevorzugt die elektrischen Parameter der Bauteile stark negativ beeinflusst.

Bevorzugt wird die Trocknungszeit und/oder die Trocknungsgeschwindigkeit und somit bevorzugt die Lösungsmittelko0mbination so gewählt, dass die Tinte gleichzeitig auch nicht zu langsam trocknet, um die Trocknungszeiten und somit die Produktionsgeschwindigkeit nicht zu limitieren.

Ein weiterer Vorteil einer Erhöhung der Viskosität der Tinte durch die Zugabe eines geeigneten dritten Lösungsmittels nach dieser Ausführungsform ist, dass eine möglichst hohe Viskosität in dem gedruckten Nassfilm ein zerfließen des Nassfilmes vorteilhafterweise verhindert und somit die Druckqualität und somit bevorzugt die Bauteilqualität erhöht.

Bei der Viskosität soll daher bevorzugt ein Trade-off zwischen hoher Viskosität und somit vorzugsweise stabilem Druckbild sowie einer bevorzugt mit niedrigerer Viskosität einhergehender erhöhter Druck- bzw. Produktionsgeschwindigkeit und bevorzugt erhöhter Druckstabilität am Druckkopf.

Als Beispiel sei ein Lösungsmittelgemisch gegeben mit 50 Gew.-% Tetrahydronaphthalen (Tetralin) + 50 Gew.-% Toluol. Tetralin hat eine hohe Oberflächenspannung, die insbesondere gemeinsam mit der erhöhten Oberflächenspannung des pyridin- und/oder thiolartige Lösungsmittels ein "dewetting" (Entnetzung) des Nassfilmes auf vielen Unterlagen bewirkt. Es wird Toluol mit einer niedrigeren Oberflächenspannung als das pyridin- und/oder thiolartige Lösungsmittel hinzugegeben, um die Benetzung des Nassfilmes auf der Druckunterlage zu verbessern. Toluol hat gleichzeitig vorzugsweise eine niedrigere Viskosität als das pyridin- und/oder thiolartige Lösungsmittel und ohne Beimischung könnte der gedruckte Nassfilm auf der Druckunterlage zerfließen. Das Tetralin, welches vorzugsweise eine höhere Viskosität als das pyridin- und/oder thiolartige Lösungsmittel aufweist, erhöht die Viskosität des Gemisches und der Nassfilm kann besser seine gedruckte Form auf der Druckunterlage behalten. Weiterhin trocknet die Tinte nur mit Zugabe von Toluol bevorzugt alleine zu schnell und die Düsen am Druckkopf würden nach kurzer Zeit eintrocknen. Die Hinzugabe von Tetralin zum Gemisch verhindert dies vorteilhafterweise. Daher ist in diesem Beispiel bevorzugt Toluol das zweite Lösungsmittel und Tetralin das dritte Lösungsmittel.

Ein Beispiel für eine bevorzugte Mischung der druckfähigen Tinte ist bevorzugt wie folgt:

| | |
|---|---|
| - Komplexierter Pseudohalogenid oder anderer anorganischer Feststoff | 0,01 % - 10% |
| - Komplexierendes pyridinartiges Lösungsmittel | 5% - 100% |
| - Lösungsmittel um Druckzu verbessern | 5% - 50% |
| - Lösungsmittel um Trocknung zu verbessern | 5% - 50%. |

Mit % sind bevorzugt Gew.-% gemeint.

In einem weiteren Aspekt betrifft die Erfindung eine druckfähige Tinte herstellbar durch ein Verfahren gemäß der vorstehenden Beschreibung.

Der durchschnittliche Fachmann erkennt, dass technische Merkmale, Definitionen und Vorteile bevorzugter Ausführungsformen des erfindungsgemäßen Verfahrens auch für die erfindungsgemäße Tinte und dessen Ausführungsformen gelten.

In einer weiteren bevorzugten Ausführungsform des erfindungsgemäßen Verfahrens gemäß vorstehender Beschreibung wird in einem sich anschließenden Schritt f) durch Aufbringen der druckfähigen Tinte mit Hilfe eines Druckverfahrens und/oder Nassprozesses eine Schicht erzeugt.

Diese Schicht kann bevorzugt z. B. auf einem Substrat oder auf einer bereits aufgebrachten weiteren Schicht eines (opto-) elektronischen Bauteils erfolgen. Bevorzugt stellt diese Schicht eine funktionelle Schicht des Bauteils da und erfüllt insbesondere eine elektrische Funktion, z. B. als Lochtransportschicht und/oder Elektronenblockschicht.

In einer weiteren bevorzugten Ausführungsform des erfindungsgemäßen Verfahrens erfolgt eine thermische Behandlung der in Schritt f) erzeugten Schicht bei einer Temperatur zwischen 50°C und 180°C, bevorzugt zwischen 120°C und 180°C, besonders bevorzugt zwischen 110°C und 150°C.

Eine thermische Behandlung kann vorzugsweise durch ein Heizelement und/oder eine elektromagnetische Bestrahlung, bspw. durch einen thermischen (Infrarot) oder UV Strahler erfolgen. Bei den Temperaturen kann vorzugsweise erreicht werden, dass pseudohalogenidhaltige oder chalkogenidhaltige Komplexe wieder in die ursprünglichen übergangsmetallhaltigen Pseudohalogenide oder Chalkogenide übergehen.

Der CuSCN Komplex kann beispielsweise bei milden Temperaturen (<120°C) wieder zu CuSCN zersetzt werden. So können vorteilhafterweise die gewünschten elektrischen Eigenschaften wieder erreicht werden, welche sich bspw. bei der Komplexierung geändert haben.

In einer weiteren bevorzugten Ausführungsform des erfindungsgemäßen Verfahrens ist das übergangsmetallhaltige Pseudohalogenid oder Chalkogenid ein vorstehend beschriebenes Material, insbesondere ein Metallthiocyanat oder Metallisothiocyanat, bevorzugt ausgewählt aus einer Gruppe umfassend Natriumthiocyanat, Kaliumthiocyanat, Silberthiocyanat, Calciumthiocyanat, Wolframthiocyanat, Vanadiumthiocyanat, Molybdänthiocyanat, Silikonthiocyanatund/oder anderen Metallthiocyanaten, besonders bevorzugt ein Kupfer(I)-Thiocyanat ist und durch die thermische Behandlung innerhalb der Schicht erfolgt eine Dotierung des Materials durch eine teilweise Oxidation des Metalls, bevorzugt des Kupfer(I) zu Kupfer (II).

Durch die thermische Behandlung, z. B. wie vorstehend beschrieben erfolgt bevorzugt eine Dotierung der Schicht. Dadurch kann vorteilhafterweise die Mobilität und/oder Anzahl der dominanten Ladungsträger erhöht werden, was die elektrischen Eigenschaften des Bauelements positiv beeinflusst. Im Beispiel des CuSCN kann bevorzugt eine teilweise Oxidation des Cu(I) zu Cu(II) erreicht werden. Dadurch lassen sich bewusst Dotierungen der entstehenden CuSCN Schicht mit Cu(II)Oxid erzeugen und somit die Ladungsträgerdichte und Mobilität erhöhen.

Bevorzugt kann durch den Anteil der teilweisen Oxidation das Ausmaß der Dotierung gesteuert werden.

Diese Ausführungsform kann sich bevorzugt ebenfalls beziehen auf ein Pseudohalogenid ausgesucht aus der Gruppe Metallcyanid, Metallfulminat, Metallcyanat, Metallselenocyanat, Metalltellurocyanat und/oder Metallazid ist, ein Pseudohalogenid, welches ein nichtlineares Metallanion, bevorzugt ausgesucht aus der Gruppe umfassend Metalldicyanamid, Metalldicyanphosphid, Metalltricyanmethanid und/oder Metallnitrosodicyanmethanid ist und/oder ein Chalkogenid, welches ein Sulfid bevorzugt ausgesucht aus einer Gruppe umfassend Cadmiumsulfid, Zinksulfid, Molybdändisulfid, Siliciumdisulfid, Wolframdisulfid, Aluminiumsulfid und/oder Vanadiumsulfid ist.

In einer weiteren bevorzugten Ausführungsform des erfindungsgemäßen Verfahrens wird das Ausmaß der Oxidation bei der thermischen Behandlung gesteuert durch
a) die Sättigung der Umgebungsatmosphäre mit Sauerstoff, wobei mehr Sauerstoff eine erhöhte Oxidation bedeutet und/oder
b) die zeitliche Änderungsrate der Temperatur bei der thermischen Behandlung, wobei eine höhere positive Änderungsrate bis zur endgültigen Ausheiztemperatur eine erhöhte Oxidation bedeutet.

So kann die Oxidation und somit die Dotierung besonders fein und flexibel über zwei verschiedene Parameter gesteuert werden. Dabei ist bevorzugt, dass eine Mindestsättigung mit Sauerstoff immer gegeben ist, da bevorzugt ohne Sauerstoff keine Oxidation stattfindet.

Die Sättigung der Umgebungsatmosphäre mit Sauerstoff bezieht sich bevorzugt auf den Anteil des Sauerstoffs an der Atmosphäre innerhalb des physikalisch möglichen Bereichs aufgrund der grundsätzlichen Zusammensetzung der Atmosphäre und der physikalischen Bedingungen wie Druck und/oder Temperatur. Ein höherer Anteil bedeutet bevorzugt eine höhere Sättigung. Ein Fachmann weiß, wie er die Sauerstoffsättigung einer Atmosphäre steuern kann, z. B. in einem abgeschlossenen Volumen.

Auch eine präzise Steuerung der Temperatur und somit auch die Steuerung deren zeitlicher Änderungsrate ist für einen Fachmann routinemäßig möglich. Es wird dabei bevorzugt von einer maximalen Ausheiztemperatur bei der thermischen Behandlung der Schicht ausgegangen und die Zeit von Anfang des Heizens bei einer ersten, bevorzugt kontrollierten Temperatur bis zum Erreichen der Ausheiztemperatur gesteuert. Eine kürzere Zeit bedeutet bevorzugt eine höhere positive Änderungsrate der Temperatur, weil die Temperatur schneller steigt. Bevorzugt steigt die Temperatur zeitlich linear an. Es kann jedoch auch ein zeitlich nichtlinearer Anstieg vorteilhaft sein. Bevorzugt ist die Abhängigkeit der Oxidation von der Temperatur ebenfalls von der Sättigung der Umgebungsatmosphäre mit Sauerstoff abhängig.

Es sollen nun beispielhafte Reaktionswege der Komplexierung und Oxidierung für CuSCN aufgezeigt werden. Die Pyridine bzw. pyridinartigen Lösungsmittel sättigen bevorzugt mit Sauerstoff an Luft und oxidieren dabei bevorzugt zu Pyridine-N-oxiden (PyO):

(1) 2 Pyridine + O2 => 2 Pyridine-N-oxide

Daher läuft die bevorzugte Komplexierung bevorzugt unterschiedlich ab, je nachdem, ob sie unter einer sauerstoffhaltigen Atmosphäre (2a) oder ohne Sauerstoff (2b) abläuft:

(2a) 2 Pyridine-N-oxide + 2 Cu(I)SCN => 2 Cu(II)[SCN][PyO]

(2b) 2 Pyridine + Cu(I)SCN => 2 Cu(I)[SCN][Py]

[Py] beschreibt dabei bevorzugt nicht oxidierte Pyridine bzw. pyridinartige Lösungsmittel. Daher läuft auch die thermische Behandlung je nach (bevorzugt vorheriger) Anwesenheit von Sauerstoff vorzugsweise unterschiedlich ab. Bei der Variante mit Sauerstoff gibt es zwei, bevorzugt parallel ablaufende Reaktionen (3a.I) und (3a.II):

(3a.I) 2 Cu(II)[SCN][PyO] + ΔT => Cu(II)O + Cu(II)SCN2 + Pyridine ↑

(3a.II) 2 Cu(II)[SCN][PyO] + ΔT => Cu2(II)[O][SCN]2 + Pyridine ↑

Dabei beschreibt ΔT bevorzugt die thermische Behandlung und ↑ bevorzugt das Ausgehen und/oder Verdunsten der Pyridine bzw. pyridinartige Lösungsmittel. (3a.I) beschreibt dabei vorzugsweise die Zersetzung des Komplexes und das Ausgehen der Pyridine bzw. pyridinartige Lösungsmittel. In (3a.II) entsteht bevorzugt ein Gemisch, welches 2 Kupferthiocyanatmoleküle durch ein Sauerstoffatom miteinander verbindet. Siehe bevorzugt auch NCS-Cu-O-Cu-SCN. War vorher kein Sauerstoff anwesend, findet vorzugsweise keine Dotierung statt:

(3b) 2 Cu(I)[SCN][Py] + ΔT => 2 Cu(I)SCN + 2 Pyridine ↑

Das zweiwertige Kupferthiocyanat aus Reaktion (3a.I) ist bevorzugt instabil und zersetzt sich selbstwieder zum Einwertigen Cu(I)SCN und einem SCN:

(4) Cu(II)SCN2 => Cu(I)SCN + SCN

Das SCN ist hier bevorzugt der p-Dotant. Der Vorgang der p-Dotierung mit SCN ist in der Literatur bekannt. Eine p-Dotierung kann bevorzugt sowohl durch entstehendes SCN als auch durch entstehendes CuO hervorgerufen werden. Besonders bevorzugt ist, dass beide Varianten (3a.I) als auch (3a.II) bei dem Vorgang passieren.

In einem weiteren Aspekt betrifft die Erfindung ein elektronisches Bauelement mit einer Kathode und einer Anode und einem Schichtsystem zwischen der Kathode und der Anode umfassend mehrere elektroaktiven Schichten, wobei das Schichtsystem mindestens eine Lochtransportschicht umfasst, herstellbar durch ein vorstehend beschriebenes Verfahren. Bevorzugt ist das elektronische Bauelement ein optoelektronisches Element, z. B. eine OLED oder eine organische Solarzelle. Es kann ebenso bevorzugt sein, dass das Bauelement ein elektronisches Element ist, z. B. ein OFET oder ein OPV.

Durch das vorstehend beschriebene Verfahren können solche Bauteile einfach und schnell, insbesondere durch ein Druckverfahren, mit hervorragenden und präzise beeinflussbaren elektrischen und/oder optischen Eigenschaften gebaut werden. Für diese Eigenschaften speilt insbesondere die Lochtransportschicht eine entscheidende Rolle.

Der durchschnittliche Fachmann erkennt, dass technische Merkmale, Definitionen und Vorteile bevorzugter Ausführungsformen des erfindungsgemäßen Verfahrens auch für das erfindungsgemäße elektronische Bauelement und dessen Ausführungsformen gelten.

In einem weiteren Aspekt betrifft die Erfindung ein optoelektronisches Bauelement wobei das Schichtsystem
- bevorzugt mindestens eine Elektroneninjektionsschicht oder -extraktionsschicht,
- mindestens eine Elektronentransportschicht und/oder Lochblockschicht
- mindestens eine optisch aktive Schicht
- mindestens eine Lochtransportschicht und/oder Elektronenblockschicht
- bevorzugt mindestens eine Lochinjektionsschicht oder -extraktionsschicht umfasst, wobei die Lochtransportschicht und/oder Elektronenblockschicht herstellbar ist durch ein Verfahren gemäß der vorstehenden Beschreibung.

Der durchschnittliche Fachmann erkennt, dass technische Merkmale, Definitionen und Vorteile bevorzugter Ausführungsformen des erfindungsgemäßen Verfahrens auch für das erfindungsgemäße optoelektronische Bauelement und dessen Ausführungsformen gelten.

Bei einem bevorzugten optoelektronischen Bauelement, bspw. einer OLED, befinden sich zwischen zwei Elektroden zumeist mehrere Schichten organische halbleitender Materialien. Insbesondere umfasst eine OLED eine oder mehrere Emitterschicht (engl. emitter layer EL), in welcher oder in welchen elektromagnetische Strahlung, bevorzugt im sichtbaren Bereich, durch eine Rekombination von Elektronen mit Elektronenlöchern erzeugt wird. Die Elektronen und Elektronenlöcher werden durch jeweils eine Kathode bzw. Anode bereitgestellt, wobei bevorzugt sogenannte Injektionsschichten durch eine Absenkung der Injektionsbarriere den Prozess erleichtern. OLEDs verfügen daher zumeist über Elektronen- bzw. Lochinjektionsschichten. Des Weiteren verfügen OLEDs in der Regel über Elektronenund Lochtransportschichten (engl. hole transport layer (HTL) oder electron transport layer (ETL)), welche die Diffusionsrichtung der Elektronen und Löcher zur Emitterschicht unterstützen. Bei OLEDs sind diese Schichten aus organischen Materialien aufgebaut, bei hybriden optoelektronischen Bauteilen können die Schichten teilweise organische teilweise auch anorganische halbleitenden Materialien umfassen. Zur sprachlichen Vereinfachung werden hybride LEDs, welche organische und anorganische Halbleiterschichten umfassen können, ebenfalls als organische Leuchtdioden (OLEDs) bezeichnet.

Die vorteilhaften Eigenschaften optoelektronischer Bauelemente umfassend organisch halbleitenden Materialien zur Lichterzeugung (OLEDs) lassen sich ebenso auf die Erzeugung von elektrischem Strom übertragen. So zeichnen sich organische Solarzellen oder hybride Solarzellen gleichfalls durch einen dünnen Schichtaufbau aus, welcher die Einsatzmöglichkeiten gegenüber klassischen anorganischen Solarzellen deutlich erhöht. Der Aufbau von organischen Solarzellen oder hybriden Solarzellen weist Ähnlichkeiten mit OLEDs oder hybriden LEDs auf. Zur sprachlichen Vereinfachung werden hybriden Solarzellen aus organischen-anorganischen Schichten ebenfalls unter den Begriff organische Solarzellen subsummiert.

Anstatt einer Emitterschicht liegen als photoaktive Schicht jedoch eine oder mehrere Absorberschichten vor. In der Absorberschicht werden aufgrund einfallender elektromagnetischer Strahlung Elektronen-Loch-Paare erzeugt. Im Gegensatz zu anorganischen Solarzellen kommt es bei der organischen Emitterschicht in der Regel zunächst zur Bildung von sogenannten Exzitonen, welche als gebundene Elektronen-Loch-Paare vorliegen. Diese werden anschließend in freie Ladungsträger getrennt.

Lochblockschichten sollen möglichst eine Injektion von Löchern aus den benachbarten Schichten verhindern. Gewünscht wird dies in z.B. OLEDs bei der Emissionsschicht. Dort ist bevorzugt, dass die Ladungsträger, Löcher und Elektronen, die Schicht nicht mehr leicht verlassen können und somit die Rekombinationsrate beider Ladungsträger in der Schicht erhöht wird. Eine Lochblockschicht würde also bevorzugt kathodenseitig angrenzend an die Emissionsschicht aufgebracht werden. Die Lochblockschicht zeichnet sich bevorzugt durch ein sehr tief liegendes HOMO Niveau aus, so das Löcher aus dem HOMO der Emissionsschicht im Wesentlichen nicht in das HOMO der Lochblockschicht injiziert werden können oder nur erschwert. Je tiefer das HOMO der Lochblockschicht gegen-über dem HOMO der Emissionsschicht, desto besser die Blockierwirkung.

Analog kann eine Elektronenblockschicht beschrieben werden, hierbei ist jedoch bevorzugt die Lage des LUMO oder *lowest unoccupied molecular orbital* entscheidend.

Mittlerweise können die Eigenschaften einer Lochblock- und einer Elektronentransportschicht bzw. einer Lochtransportschicht und/oder Elektronenblockschicht vorzugsweise von einem einzigen Material bzw. einer einzigen Schicht erfüllt werden.

Es ist bevorzugt, möglichst das gesamte optoelektronische Bauelement durch ein nasschemisches Verfahren, insbesondere ein Druckverfahren herzustellen. Gleichzeitig sollen alle Schichten für sich genommen und in der Kombination besonders vorteilhafte elektrische Eigenschaften aufweisen. Durch die Herstellung der Lochtransportschicht und/oder Elektronenblockschicht durch das vorgenannte Verfahren können diese Ziele erreicht und die Eigenschaften des Bauelements weiter verbessert werden.

### Detaillierte Beschreibung

Im Folgenden soll die Erfindung anhand von Beispielen und Figuren näher erläutert werden, ohne auf diese beschränkt zu sein.

### Kurzbeschreibung der Abbildungen

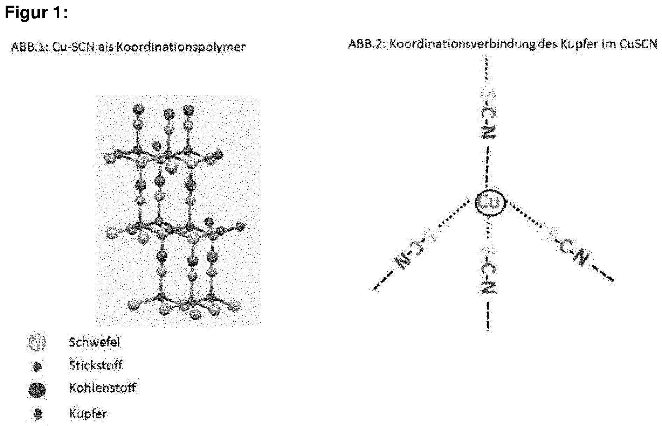

**Figur 1** zeigt eine schematische Darstellung eines CuSCN-Moleküls.

### Detaillierte Beschreibung der Abbildung

CuSCN ist ein Pseudohalogenid und bildet als Kristallstruktur ein Koordinationsnetzwerk, siehe Figur 1, linke Seite. Es gehört zur Klasse der Koordinationspolymere, sprich anorganischen Polymere. Das Kupfer-Zentralatom koordiniert von drei Seiten mit dem Schwefelatom der Thiocyanat-Gruppe und von einer weiteren Seite mit dem Stickstoffatom der Thiocyanat Gruppe, siehe Figur 1, rechts.

Es wird darauf hingewiesen, dass verschiedene Alternativen zu den beschriebenen Ausführungsformen der Erfindung verwendet werden können, um die Erfindung auszuführen und zu der erfindungsgemäßen Lösung zu gelangen. Die erfindungsgemäße Vorrichtung sowie das System beschränken sich in ihren Ausführungen somit nicht auf die vorstehenden bevorzugten Ausführungsformen. Vielmehr ist eine Vielzahl von Ausgestaltungsvarianten denkbar, welche von der dargestellten Lösung abweichen können. Ziel der Ansprüche ist es, den Schutzumfang der Erfindung zu definieren. Der Schutzumfang der Ansprüche ist darauf gerichtet, das erfindungsgemäße Verfahren und das Bauelement abzudecken.

## Patentansprüche

1. Verfahren umfassend folgende Schritte:
a) Bereitstellung eines übergangsmetallhaltigen Pseudohalogenids oder Chalkogenids als Feststoff
b) Bereitstellung eines pyridinartigen oder thiolartigen Lösungsmittels
c) Mischung des Pseudohalogenids oder Chalkogenids mit dem pyridinartigen oder thiolartigen Lösungsmittel, sodass pseudohalogenidhaltige oder chalkogenidhaltige Komplexe entstehen
d) Filtern der pseudohalogenidhaltigen oder chalkogenidhaltigen Komplexe aus der Mischung aus dem vorherigen Schritt
e) Mischen der pseudohalogenidhaltigen oder chalkogenidhaltigen Komplexe mit dem pyridinartigen oder thiolartigen Lösungsmittel und/oder mit einem oder mehreren weiteren Lösungsmitteln zur Herstellung einer druckfähigen Tinte

2. Verfahren gemäß dem vorherigen Anspruch
**dadurch gekennzeichnet, dass**
das Pseudohalogenid ein Metallthiocyanat oder Metallisothiocyanat bevorzugt ausgewählt aus einer Gruppe umfassend Natriumthiocyanat, Kaliumthiocyanat, Silberthiocyanat, Calciumthiocyanat, Wolframthiocyanat, Vanadiumthiocyanat, Molybdänthiocyanat, Silikonthiocyanatund/oder anderen Metallthiocyanaten, besonders bevorzugt ein Kupfer(I)-Thiocyanat, ist.

3. Verfahren gemäß Anspruch 1
**dadurch gekennzeichnet, dass**
das Pseudohalogenid ausgesucht ist aus der Gruppe Metallcyanid, Metallfulminat, Metallcyanat, Metallselenocyanat, Metalltellurocyanat und/oder Metallazid
oder
das Pseudohalogenid ein nichtlineares Metallanion, bevorzugt ausgesucht aus der Gruppe umfassend Metalldicyanamid, Metalldicyanphosphid, Metalltricyanmethanid und/oder Metallnitrosodicyanmethanid, ist.

4. Verfahren gemäß Anspruch 1
**dadurch gekennzeichnet, dass**
das Chalkogenid ein Sulfid bevorzugt ausgesucht aus einer Gruppe umfassend Cadmiumsulfid, Zinksulfid, Molybdändisulfid, Siliciumdisulfid, Wolframdisulfid, Aluminiumsulfid und/oder Vanadiumsulfid ist.

5. Verfahren gemäß einem der vorherigen Ansprüche
**dadurch gekennzeichnet, dass**
das übergangsmetallhaltige Pseudohalogenid oder Chalkogenid ein Material aus Anspruch 2 ist, bevorzugt ein Kupfer(I)-Thiocyanat ist,
wobei in Schritt c) eine Dotierung des Materials durch eine teilweise Oxidation des Metalls, bevorzugt des Kupfer(I) zu Kupfer (II) erfolgt und
das Ausmaß der Oxidation bei der Komplexierung gesteuert wird durch das Verhältnis von Feststoff zum pyridinartigen oder thiolartigen Lösungsmittel, wobei ein höheres Verhältnis eine erhöhte Oxidation bedeutet.

6. Verfahren gemäß einem der vorherigen Ansprüche
**dadurch gekennzeichnet, dass**
das pyridinartige Lösungsmittel ein Pyridin ist, an welchem mindestens eine Position des Pyridinringes durch eine Gruppe ausgesucht aus einer Gruppe umfassend eine Alkylgruppe, eine Carboxylgruppe, eine Acetylgruppe, eine Hydroxylgruppe und/oder eine Thiolygruppe und/oder ein Halogen substituiert ist,
wobei das pyridinartige Lösungsmittel bevorzugt ausgewählt ist aus einer Gruppe umfassend Methylpyridine, Ethylpyridine, Bromopyridine und/oder Tert-Butylpyridine.

7. Verfahren gemäß einem der vorherigen Ansprüche
**dadurch gekennzeichnet, dass**
das thiolartige Lösungsmittel ausgewählt aus einer Gruppe umfassend Thioanisole, Alkylthiophene, Allylthiophene, Thioglycolsäuren ist.

8. Verfahren gemäß einem der vorherigen Ansprüche
**dadurch gekennzeichnet, dass**
die druckfähige Tinte
a) 0,1 - 10 Gew.-% der pseudohalogenidhaltigen Komplexe und
b) 5 - 99,9 Gew.-% des pyridinartigen oder thiolartigen Lösungsmittels umfasst, wobei sich die Gew.-%) auf das Gesamtgewicht der Tinte beziehen und die Summe der Gew.-% kleiner oder gleich 100 ist.

9. Verfahren gemäß einem der vorherigen Ansprüche
**dadurch gekennzeichnet, dass**
die druckfähige Tinte
a) 0,1 - 10 Gew.-% der pseudohalogenidhaltigen oder chalkogenidhaltigen Komplexe und
b) 5 - 99,7 Gew.-% des pyridinartigen oder thiolartigen Lösungsmittels,
c) 0,1 - 50 Gew.-% eines zweiten Lösungsmittels, welches flüssig bei Normbedingungen ist,
d) 0,1 - 50 Gew.-% eines dritten Lösungsmittels, welches flüssig bei Normbedingungen ist
umfasst, wobei sich die Gew.-%) auf das Gesamtgewicht der Tinte beziehen und die Summe der Gew.-% kleiner oder gleich 100 ist,
wobei bevorzugt das zweite Lösungsmittel die Druckfähigkeit der Tinte erhöht, wobei das das zweite Lösungsmittel ein Lösungsmittel mit niedrigerer Oberflächenspannung bei Normbedingungen als das pyridinartige oder thiolartige Lösungsmittel ist und/oder
das dritte Lösungsmittel die Trocknungszeit der Tinte erhöht, wobei das das dritte Lösungsmittel ein Lösungsmittel mit höherer Viskosität bei Normbedingungen als das pyridinartige oder thiolartige Lösungsmittel ist.

10. Druckfähige Tinte herstellbar durch ein Verfahren gemäß einem der vorherigen Ansprüche 1-9.

11. Verfahren gemäß einem der Ansprüche **1-9**
**dadurch gekennzeichnet, dass**
in einem sich anschließenden Schritt f) durch Aufbringen der druckfähigen Tinte mit Hilfe eines Druckverfahrens und/oder Nassprozesses eine Schicht erzeugt wird,
wobei bevorzugt eine thermische Behandlung der in Schritt f) erzeugten Schicht bei einer Temperatur zwischen 50°C und 180°C, bevorzugt zwischen 120°C und 180°C, besonders bevorzugt zwischen 110°C und 150°C erfolgt.

12. Verfahren gemäß dem vorherigen Anspruch
**dadurch gekennzeichnet, dass**
das übergangsmetallhaltige Pseudohalogenid oder Chalkogenid ein Material aus Anspruch 2 ist, bevorzugt ein Kupfer(I)-Thiocyanat ist und durch die thermische Behandlung innerhalb der Schicht eine Dotierung des Materials durch eine teilweise Oxidation des Metalls, bevorzugt des Kupfer(I) zu Kupfer (II) erfolgt.

13. Verfahren gemäß dem vorherigen Anspruch
**dadurch gekennzeichnet, dass**
das Ausmaß der Oxidation bei der thermischen Behandlung gesteuert wird durch
a) die Sättigung der Umgebungsatmosphäre mit Sauerstoff, wobei mehr Sauerstoff eine erhöhte Oxidation bedeutet und/oder
b) die zeitliche Änderungsrate der Temperatur bei der thermischen Behandlung, wobei eine höhere positive Änderungsrate bis zur endgültigen Ausheiztemperatur eine erhöhte Oxidation bedeutet.

14. Elektronisches Bauelement mit einer Kathode und einer Anode und einem Schichtsystem zwischen der Kathode und der Anode umfassend mehrere elektroaktiven Schichten
**dadurch gekennzeichnet, dass**
das Schichtsystem mindestens eine Lochtransportschicht umfasst, herstellbar durch ein Verfahren gemäß der Ansprüche **11-13.**

15. Optoelektronisches Bauelement gemäß dem vorherigen Anspruch
**dadurch gekennzeichnet, dass**
das Schichtsystem
- bevorzugt mindestens eine Elektroneninjektionsschicht oder - extraktionsschicht,
- mindestens eine Elektronentransportschicht und/oder Lochblockschicht
- mindestens eine optisch aktive Schicht
- mindestens eine Lochtransportschicht und/oder Elektronenblockschicht
- bevorzugt mindestens eine Lochinjektionsschicht oder -extraktionsschicht umfasst,
wobei die Lochtransportschicht und/oder Elektronenblockschicht herstellbar ist durch ein Verfahren gemäß der Ansprüche **11-13.**

## Claims

1. Method comprising the following steps:
a) Providing a transition metal-containing pseudohalide or chalcogenide as a solid
b) Providing a pyridine-like or thiol-like solvent
c) Mixing the pseudohalide or chalcogenide with the pyridine-like or thiol-like solvent to form pseudohalide or chalcogenide-containing complexes
d) Filtering the pseudohalide or chalcogenide complexes from the mixture from the previous step
e) Mixing the pseudohalide or chalcogenide-containing complexes with the pyridine-like or thiol-like solvent and/or with one or more other solvents to produce a printable ink.

2. Method according to the previous claim
**characterized in that**
the pseudohalide is a metal thiocyanate or metal isothiocyanate preferably selected from a group comprising sodium thiocyanate, potassium thiocyanate, silver thiocyanate, calcium thiocyanate, tungsten thiocyanate, vanadium thiocyanate, molybdenum thiocyanate, silicone thiocyanate and/or other metal thiocyanates, most preferably a copper (I) thiocyanate.

3. Method according to claim 1
**characterized in that**
the pseudohalide is selected from the group consisting of metal cyanide, metal fulminate, metal cyanate, metal selenocyanate, metal tellurium cyanate and/or metal azide or
the pseudohalide is a nonlinear metal anion, preferably selected from the group comprising metal dicyanamide, metal dicyanophosphide, metal tricyanomethanide and/or metal nitrosodicyanomethanide.

4. Method according to claim 1
**characterized in that**
the chalcogenide is a sulfide preferably selected from a group comprising cadmium sulfide, zinc sulfide, molybdenum disulfide, silicon disulfide, tungsten disulfide, aluminum sulfide and/or vanadium sulfide.

5. Method according to one of the previous claims
**characterized in that**
the transition metal-containing pseudohalide or chalcogenide is a material of claim 2, preferably a copper (I) thiocyanate, wherein in step c) a doping of the material takes place by a partial oxidation of the metal, preferably of the copper (I) to copper (II) and the degree of oxidation during complexation is controlled by the ratio of solid to pyridine-like or thiol-like solvent, where a higher ratio means increased oxidation.

6. Method according to one of the previous claims
**characterized in that**
the pyridine-like solvent is a pyridine in which at least one position of the pyridine ring is substituted by a group selected from a group comprising an alkyl group, a carboxyl group, an acetyl group, a hydroxyl group and/or a thiol group and/or a halogen, wherein the pyridine-like solvent is preferably selected from a group comprising methylpyridines, ethylpyridines, bromopyridines and/or tert-butylpyridines.

7. Method according to one of the previous claims
**characterized in that**
the thiol-like solvent is selected from a group comprising thioanisols, alkylthiophenes, allylthiophenes, thioglycolic acids.

8. Method according to one of the previous claims
**characterized in that**
the printable ink comprises
a) 0.1 - 10% by weight of pseudohalide containing complexes and
b) 5 - 99.9 % by weight of the pyridine-like or thiol-like solvent
wherein the % by weight is based on the total weight of the ink and the sum of the % by weight is less than or equal to 100.

9. Method according to one of the previous claims
**characterized in that**
the printable ink comprises
a) 0.1 - 10% by weight of pseudohalide or chalcogenide-containing complexes
b) 5 - 99.7 % by weight of the pyridine-like or thiol-like solvent,
c) 0.1-50% by weight of a second solvent which is liquid at standard conditions,
d) 0.1 - 50% by weight of a third solvent which is liquid at standard conditions
wherein the % by weight is based on the total weight of the ink and the sum of the % by weight is less than or equal to 100, wherein preferably the second solvent increases the printability of the ink, wherein the second solvent is a solvent with a lower surface tension at standard conditions than the pyridine-like or thiol-like solvent and/or
the third solvent increases the drying time of the ink, wherein the third solvent is a solvent with a higher viscosity at standard conditions than the pyridine-like or thiol-like solvent.

10. Printable ink producible by a method according to any of the previous claims 1-9.

11. Method according to any of claims 1-9
**characterized in that**
in a subsequent step f) a layer is produced by applying the printable ink by means of a printing method and/or a wet process,
wherein preferably a thermal treatment of the layer produced in step f) is carried out at a temperature between 50°C and 180°C, preferably between 120°C and 180°C, especially preferably between 110°C and 150°C.

12. Method according to the previous claim
**characterized in that**
the transition metal-containing pseudohalide or chalcogenide is a material from claim 2, preferably a copper(I) thiocyanate, and the thermal treatment within the layer results in doping of the material by partial oxidation of the metal, preferably copper(I) to copper (II).

13. Method according to the previous claim
**characterized in that**
the degree of oxidation during thermal treatment is controlled by
a) the saturation of the ambient atmosphere with oxygen, whereby more oxygen means increased oxidation and/or
b) the rate of temperature change over time during thermal treatment, whereby a higher positive rate of change until the final bakeout temperature means increased oxidation.

14. Electronic component with a cathode and an anode and a layer system between the cathode and the anode comprising several electroactive layers
**characterized in that**
the layer system comprises at least a hole transport layer, producible by a method according to claims **11-13.**

15. Optoelectronic component according to the previous claim
**characterized in that**
the layer system comprises
- preferably at least one electron injection layer or electron extraction layer,
- at least one electron transport layer and/or hole block layer
- at least one optically active layer
- at least one hole transport layer and/or electron block layer
- preferably at least one hole injection layer or hole extraction layer,
wherein the hole transport layer and/or the electron block layer can be produced by a method according to claims **11-13.**

## Revendications

1. Procédé comprenant des étapes suivantes :
a) la fourniture d'un pseudo-halogénure ou chalcogénure contenant un métal de transition en tant que matière solide,
b) la fourniture d'un solvant de type pyridine ou de type thiol,
c) le mélange du pseudo-halogénure ou chalcogénure avec le solvant de type pyridine ou de type thiol de manière à obtenir des complexes contenant un pseudo-halogénure ou contenant un chalcogénure,
d) la filtration des complexes contenant un pseudo-halogénure ou contenant un chalcogénure hors du mélange issu de l'étape précédente,
e) le mélange des complexes contenant un pseudo-halogénure ou contenant un chalcogénure avec le solvant de type pyridine ou de type thiol et/ou avec un ou plusieurs autres solvants pour produire une encre imprimable

2. Procédé selon la revendication précédente,
**caractérisé en ce que**
le pseudo-halogénure est un thiocyanate de métal ou un isothiocyanate de métal choisi de manière préférée parmi le groupe comprenant du thiocyanate de sodium, du thiocyanate de potassium, du thiocyanate d'argent, du thiocyanate de calcium, du thiocyanate de tungstène, du thiocyanate de vanadium, du thiocyanate de molybdène, du thiocyanate de silicone et/ou d'autres thiocyanates de métal, de manière particulièrement préférée est un thiocyanate de cuivre(I).

3. Procédé selon la revendication 1,
**caractérisé en ce que**
le pseudo-halogénure est sélectionné parmi le groupe du cyanure de métal, du fulminate de métal, du cyanate de métal, du sélénocyanate de métal, du tellurocyanate de métal et/ou de l'azoture de métal
ou
le pseudo-halogénure est un anion métallique non linéaire, sélectionné de manière préférée parmi le groupe comprenant du dicyanamide de métal, du dicyanphosphure de métal, du tricyanméthanure de métal et/ou du nitrosodicyanméthanure de métal.

4. Procédé selon la revendication 1,
**caractérisé en ce que**
le chalcogénure est un sulfure sélectionné de manière préférée parmi un groupe comprenant du sulfure de cadmium, du sulfure de zinc, du disulfure de molybdène, du disulfure de silicium, du disulfure de tungstène, du sulfure d'aluminium et/ou du sulfure de vanadium.

5. Procédé selon l'une quelconque des revendications précédentes,
**caractérisé en ce que**
le pseudo-halogénure ou chalcogénure contenant du métal de transition est un matériau issu de la revendication 2, de manière préférée est un thiocyanate de cuivre(I),
dans lequel un dopage du matériau est effectué à l'étape c) par une oxydation partielle du métal, de manière préférée du cuivre(I) en cuivre (II), et
l'ampleur de l'oxydation lors de la complexation est commandée par le rapport entre la matière solide et le solvant de type pyridine ou de type thiol, dans lequel un rapport supérieur signifie une oxydation plus importante.

6. Procédé selon l'une quelconque des revendications précédentes,
**caractérisé en ce que**
le solvant de type pyridine est une pyridine, sur lequel au moins une position du cycle pyridine est substituée par un groupe sélectionné parmi un groupe comprenant un groupe alkyle, un groupe carboxyle, un groupe acétyle, un groupe hydroxyle et/ou un groupe thiol et/ou un halogénure,
dans lequel le solvant de type pyridine est de manière préférée choisi parmi un groupe comprenant des méthylpyridines, des éthylpyridines, des bromopyridines et/ou des tert-butylpyridines.

7. Procédé selon l'une quelconque des revendications précédentes,
**caractérisé en ce que**
le solvant de type thiol est choisi parmi un groupe comprenant des thioanisoles, des alkylthiophènes, des allylthiophènes, des acides thioglycoliques.

8. Procédé selon l'une quelconque des revendications précédentes,
**caractérisé en ce que**
l'encre imprimable comprend
a) 0,1 - 10 % en poids des complexes contenant du pseudo-halogénure et
b) 5 - 99,9 % en poids du solvant de type pyridine ou de type thiol, dans lequel les % en poids se rapportent au poids total de l'encre et la somme des % en poids est inférieure ou égale à 100.

9. Procédé selon l'une quelconque des revendications précédentes,
**caractérisé en ce que**
l'encre imprimable comprend
a) 0,1 - 10 % en poids des complexes contenant du pseudo-halogénure ou contenant du chalcogénure, et
b) 5 - 99,7 % en poids du solvant de type pyridine ou de type thiol,
c) 0,1 - 50 % en poids d'un deuxième solvant, lequel est liquide dans des conditions normales,
d) 0,1 - 50 % en poids d'un troisième solvant, lequel est liquide dans des conditions normales,
dans lequel les % en poids se rapportent au poids total de l'encre et la somme des % en poids est inférieure ou égale à 100,
dans lequel de manière préférée le deuxième solvant augmente l'imprimabilité de l'encre, dans lequel le deuxième solvant est un solvant avec une tension surfacique inférieure dans des conditions normales à celle du solvant de type pyridine ou de type thiol,
et/ou
le troisième solvant augmente le temps de séchage de l'encre, dans lequel le troisième solvant est un solvant avec une viscosité supérieure dans des conditions normales à celle du solvant du type pyridine ou de type thiol.

10. Encre imprimable pouvant être produite par un procédé selon l'une quelconque des revendications 1 - 9.

11. Procédé selon l'une quelconque des revendications 1 - 9, **caractérisé en ce que**
une couche est générée dans une étape f) s'y raccordant par application de l'encre imprimable à l'aide d'un procédé d'impression et/ou d'un procédé humide,
dans lequel de manière préférée un traitement thermique de la couche générée à l'étape f) est effectué à une température entre 50 °C et 180 °C, de manière préférée entre 120 °C et 180 °C, de manière particulièrement préférée entre 110 °C et 150 °C.

12. Procédé selon la revendication précédente,
**caractérisé en ce que**
le pseudo-halogénure ou chalcogénure contenant un métal de transition est un matériau issu de la revendication 2, de manière préférée est un thiocyanate de cuivre (I) et un dopage du matériau est effectué par le traitement à l'intérieur de la couche par une oxydation partielle du métal, de manière préférée du cuivre(I) en cuivre(II).

13. Procédé selon la revendication précédente,
**caractérisé en ce que**
l'ampleur de l'oxydation lors du traitement thermique est commandée par
a) la saturation de l'atmosphère ambiante en oxygène, dans lequel davantage d'oxygène signifie une oxydation plus importante, et/ou
b) la vitesse de variation dans le temps de la température lors du traitement thermique, dans lequel une vitesse de variation positive supérieure jusqu'à la température de chauffage finale signifie une oxydation plus importante.

14. Composant électronique avec une cathode et une anode et un système de couches entre la cathode et l'anode comprenant plusieurs couches électroactives,
**caractérisé en ce que**
le système de couches comprend au moins une couche de transport de trous pouvant être produite par un procédé selon les revendications 11 - 13.

15. Composant optoélectronique selon la revendication précédente,
**caractérisé en ce que**
le système de couches comprend
- de manière préférée au moins une couche d'injection ou une couche d'extraction d'électrons,
- au moins une couche de transport d'électrons et/ou une couche de blocage de trou,
- au moins une couche optiquement active,
- au moins une couche de transport de trous et/ou une couche de blocage d'électrons,
- de manière préférée au moins une couche d'injection ou une couche d'extraction de trou,
dans lequel la couche de transport de trous et/ou la couche de blocage d'électrons peuvent être produites par un procédé selon les revendications 11 - 13.
